(19)

Europäisches
Patentamt
European
Patent Office
Office européen
des brevets

(11) **EP 4 261 574 A1**

(12) **EUROPEAN PATENT APPLICATION**

(43) Date of publication:
**18.10.2023 Bulletin 2023/42**

(21) Application number: **23163858.6**

(22) Date of filing: **23.03.2023**

(51) International Patent Classification (IPC):
**G02B 3/00** $^{(2006.01)}$     **G02B 3/14** $^{(2006.01)}$
**G02B 5/30** $^{(2006.01)}$     **G02B 26/06** $^{(2006.01)}$
**G02B 27/00** $^{(2006.01)}$     **G02B 27/01** $^{(2006.01)}$
**G02F 1/01** $^{(2006.01)}$

(52) Cooperative Patent Classification (CPC):
**G02B 3/0043; G02B 3/14; G02B 5/1809;**
**G02B 5/30; G02B 5/3016; G02B 27/0018;**
**G02B 27/0037; G02B 27/0172; G02F 1/0136;**
G02B 27/30; G02B 2027/012

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: **14.04.2022 US 202217721220**

(71) Applicant: **Meta Platforms Technologies, LLC**
**Menlo Park, CA 94025 (US)**

(72) Inventors:
• **CHEN, Dong**
**Menlo Park, 94025 (US)**

• **LEE, Yun-Han**
**Menlo Park, 94025 (US)**
• **LEE, Kilbock**
**Menlo Park, 94025 (US)**
• **ZHUANG, Zhiming**
**Menlo Park, 94025 (US)**
• **NAM, Donghee**
**Menlo Park, 94025 (US)**
• **SONG, Hyunmin**
**Menlo Park, 94025 (US)**

(74) Representative: **Murgitroyd & Company**
**Murgitroyd House**
**165-169 Scotland Street**
**Glasgow G5 8PL (GB)**

(54) **PBP MICRO-LENS FOR MICRO-OLED BEAM TUNING**

(57)     A micro-light emitting diode device includes a backplane including drive circuits formed thereon, an array of micro-LEDs bonded to the backplane and electrically coupled to the drive circuits, an array of polarization diffraction micro-lenses bonded to the array of micro-LEDs and including a planar surface, and a cover glass bonded to the planar surface of the array of polarization diffraction micro-lenses. A center of each polarization diffraction micro-lens of the array of polarization diffraction micro-lenses aligns with a center of a respective micro-LED of the array of micro-LEDs.

**FIG. 7A**

EP 4 261 574 A1

**Description**

TECHNICAL FIELD

This disclosure relates generally to near-eye displays such as head-mounted displays. More specifically, and without limitation, techniques disclosed herein relate to near-eye displays that include images sources having polarization diffraction micro-lenses for beam collimation and beam deflection.

BACKGROUND

An artificial reality system, such as a head-mounted display (HMD) or heads-up display (HUD) system, generally includes a near-eye display system in the form of a headset or a pair of glasses and configured to present content to a user via an electronic or optic display within, for example, about 10-20 mm in front of the user's eyes. The near-eye display system may display virtual objects or combine images of real objects with virtual objects, as in virtual reality (VR), augmented reality (AR), or mixed reality (MR) applications. For example, in an AR system, a user may view both images of virtual objects (e.g., computer-generated images (CGIs)) and the surrounding environment by, for example, seeing through transparent display glasses or lenses (often referred to as optical see-through) or viewing displayed images of the surrounding environment captured by a camera (often referred to as video see-through). The display system generally includes one or more light sources that can be driven to output light at various luminance levels to form display images, such as light-emitting diodes (LEDs), organic LEDs (OLEDs), quantum dot LEDs (QLEDs), Quantum Dot Electro Luminescent (QDEL) devices, and Perovskite LEDs (PeLEDs). For example, semiconductor micro-LEDs or micro-OLEDs that emit light of different colors (e.g., red, green, and blue) can be used to form the sub-pixels of a near-eye display system, due to their small size (e.g., with a linear dimension less than about 50 $\mu$m, less than about 20 $\mu$m, less than 10 $\mu$m, or less than 5 $\mu$m), high packing density (and hence higher resolution), and high brightness.

SUMMARY

Various inventive embodiments are described herein, including devices, systems, methods, structures, materials, processes, and the like.

According to a first aspect, there is provided a micro-light emitting diode (micro-LED) device comprising: a backplane including drive circuits formed thereon; an array of micro-LEDs bonded to the backplane and electrically coupled to the drive circuits; an array of polarization diffraction micro-lenses bonded to the array of micro-LEDs and including a planar surface, wherein a center of each polarization diffraction micro-lens of the array of polarization diffraction micro-lenses aligns with a center of a respective micro-LED of the array of micro-LEDs; and a cover glass bonded to the planar surface of the array of polarization diffraction micro-lenses. The micro-LED device may include a circular polarizer.

The array of polarization diffraction micro-lenses may be configured to collimate light beams emitted by the array of micro-LEDs. The array of polarization diffraction micro-lenses may be configured to deflect chief rays of light beams emitted by the array of micro-LEDs by different deflection angles that gradually increase from a center of the micro-LED device to an edge of the micro-LED device. An optical axis of a polarization diffraction micro-lens of the array of polarization diffraction micro-lenses may be offset from the center of the polarization diffraction micro-lens.

A first polarization diffraction micro-lens of the array of polarization diffraction micro-lenses may be characterized by a first offset between an optical axis of the first polarization diffraction micro-lens and the center of the first polarization diffraction micro-lens. A second polarization diffraction micro-lens of the array of polarization diffraction micro-lenses may be characterized by a second offset between an optical axis of the second polarization diffraction micro-lens and the center of the second polarization diffraction micro-lens, where the second offset is different from the first offset.

Each polarization diffraction micro-lens of the array of polarization diffraction micro-lenses may be characterized by a positive optical power for light of a first circular polarization state and a negative optical power for light of a second circular polarization state. The array of polarization diffraction micro-lenses may include Pancharatnam-Berry Phase (PBP) micro-lenses. Each polarization diffraction micro-lens of the array of polarization diffraction micro-lenses may include: an alignment layer including an alignment pattern formed thereon; and liquid crystal molecules arranged according to the alignment pattern. A pitch of the array of micro-LEDs may be equal to a pitch of the array of polarization diffraction micro-lenses.

The array of micro-LEDs may include: an array of micro-organic light emitting diodes (micro-OLEDs) configured to emit red, green, and blue light; an array of III-V semiconductor micro-LEDs configured to emit red, green, and blue light; and/or an array of color filters and an array of micro-OLEDs configured to emit white light. The color filters may be configured to filter the white light such that red, green and blue light is provided. The array of micro-LEDs may include an array of pixels. Each pixel of the array of pixels may include: a first micro-LED configured to emit light in a first wavelength range; a second micro-LED configured to emit light in a second wavelength range; and a third micro-LED configured to emit light in a third wavelength range. Three polarization diffraction micro-lenses of the array of polarization diffraction micro-lenses may be configured to deflect chief rays of light beams emitted by the first micro-LED, the second micro-LED, and the third micro-LED by a same deflection angle.

According to a second aspect, there is provided a near-eye display system comprising: an image source configured to generate display light, the image source comprising: a backplane including drive circuits formed thereon; an array of micro-LEDs bonded to the backplane and electrically coupled to the drive circuits; an array of polarization diffraction micro-lenses aligned with the array of micro-LEDs and including a planar surface, wherein a pitch of the array of polarization diffraction micro-lenses is equal to a pitch of the array of micro-LEDs; and a cover glass bonded to the planar surface of the array of polarization diffraction micro-lenses; and display optics configured to project the display light emitted by the image source to an eye box of the near-eye display system. The near-eye display system may also include a circular polarizer between the image source and the display optics.

The array of polarization diffraction micro-lenses may be configured to direct chief rays of light beams emitted by the array of micro-LEDs onto the display optics at different incident angles. The array of polarization diffraction micro-lenses may be configured to deflect chief rays of light beams emitted by the array of micro-LEDs by different deflection angles that gradually increase from a center of the image source to an edge of the image source. An optical axis of a polarization diffraction micro-lens of the array of polarization diffraction micro-lenses may be offset from a center of the polarization diffraction micro-lens. The array of polarization diffraction micro-lenses may include PBP micro-lenses. Each PBP micro-lens of the PBP micro-lenses may have a positive optical power for light of a first circular polarization state and a negative optical power for light of a second circular polarization state. Each polarization diffraction micro-lens of the array of polarization diffraction micro-lenses may include: an alignment layer including an alignment pattern formed thereon; and liquid crystal molecules arranged according to the alignment pattern. The array of micro-LEDs may include: an array of micro-organic light emitting diodes (micro-OLEDs) configured to emit red, green, and blue light; an array of III-V semiconductor micro-LEDs configured to emit red, green, and blue light; and/or an array of color filters and an array of micro-OLEDs configured to emit white light. The color filters may be configured to filter the white light such that red, green and blue light is provided.

Any feature disclosed with regards to one aspect may be incorporated into another aspect. This summary is neither intended to identify key or essential features of the claimed subject matter, nor is it intended to be used in isolation to determine the scope of the claimed subject matter. The subject matter should be understood by reference to appropriate portions of the entire specification of this disclosure, any or all drawings, and each claim. The foregoing, together with other features and examples, will be described in more detail below in the following specification, claims, and accompanying drawings.

BRIEF DESCRIPTION OF THE DRAWINGS

Illustrative eexamples are described in detail below with reference to the following figures.

FIG. 1 is a simplified block diagram of an example of an artificial reality system environment including a near-eye display.

FIG. 2 is a perspective view of an example of a near-eye display in the form of a head-mounted display (HMD) device for implementing some of the examples disclosed herein.

FIG. 3 is a perspective view of an example of a near-eye display in the form of a pair of glasses for implementing some of the examples disclosed herein.

FIG. 4 is a cross-sectional view of an example of a near-eye display.

FIG. 5 illustrates an example of an optical system with a non-pupil forming configuration for a near-eye display device.

FIG. 6 illustrates an example of an optical see-through augmented reality system including a waveguide display.

FIG. 7A illustrates an example of a micro-OLED display system.

FIG. 7B illustrates an example of a micro-OLED display system including polarization diffraction micro-lenses for light extraction and beam collimation.

FIG. 8A is a view of an x-z plane of an example of a PBP grating.

FIG. 8B is a view of an x-y plane of the example of PBP grating shown in FIG. 8A.

FIG. 9A illustrates liquid crystal (LC) molecule orientations in an example of a PBP lens.

FIG. 9B illustrates the LC molecule orientations of a portion of the PBP lens of FIG. 9A.

FIGS. 10A and 10B illustrate an example of a PBP lens sensitive to circularly polarized light.

FIG. 11A illustrates an example of a micro-LED-based display system including a micro-LED array and display optics.

FIG. 11B illustrates angles of light incident on the display optics from the micro-LED array of FIG. 11A.

FIG. 11C illustrates an example of the portions of light beams emitted by the micro-LED array of FIG. 11A that may be collected and projected by the display optics to user's eyes.

FIG. 12A illustrates an example of a micro-OLED device including a micro-OLED array and a micro-lens array for extracting and converging light from the micro-OLED array.

FIG. 12B illustrates an example of the portions of the light beams emitted by the micro-OLED array of the micro-OLED device of FIG. 12A that may be collected by the display optics.

FIG. 13A illustrates an example of a micro-OLED device.

FIG. 13B illustrates an example of a micro-OLED device including polarization diffraction micro-lenses for light extraction and beam shaping.

FIG. 13C illustrates an example of the array of polarization diffraction micro-lenses of FIG. 13B.

FIG. 14 illustrates an example of an array of polarization diffraction micro-lenses.

FIGS. 15A-15D illustrate an example of a process of fabricating polarization diffraction micro-lenses disclosed herein.

FIG. 15E illustrates an example of a process for a patterning alignment layer using direct laser writing techniques.

FIGS. 16A-16D illustrate an example of a process of fabricating polarization diffraction micro-lenses disclosed herein.

FIG. 17 includes a flowchart illustrating an example of a process of fabricating a micro-LED device.

FIG. 18 is a simplified block diagram of an example of an electronic system of a near-eye display.

The figures depict examples of the present disclosure for purposes of illustration only. One skilled in the art will readily recognize from the following description that alternative examples and embodiments of the structures and methods illustrated may be employed without departing from the principles, or benefits touted, of this disclosure.

In the appended figures, similar components and/or features may have the same reference label. Further, various components of the same type may be distinguished by following the reference label by a dash and a second label that distinguishes among the similar components. If only the first reference label is used in the specification, the description is applicable to any one of the similar components having the same first reference label irrespective of the second reference label.

DETAILED DESCRIPTION

Augmented reality (AR) and virtual reality (VR) applications may use near-eye displays (e.g., head-mounted displays) that include arrays of tiny monochrome light emitters, such as mini-light emitting diodes (mini-LEDs) or micro-light emitting diodes (micro-LEDs). The light emitting diodes (LEDs) may include, for example, III-V semiconductor LEDs, organic LEDs (OLEDs), quantum dot LEDs (QLEDs), Quantum Dot Electro Luminescent (QDEL) devices, and Perovskite LEDs (PeLEDs). In some VR displays, light emitted by an array (e.g., a two-dimensional array) of light emitters may be projected by display optics to user's eyes, where the overall efficiency may be determined by the external quantum efficiency (EQE) of each light emitter and the efficiency of the display optics for directing the emitted light to the eyebox of a display system. In some AR displays, light emitted by an array of light emitters may be collimated and coupled into a combiner (*e.g.*, a transparent waveguide) for delivering display images and ambient environment images to the user's eyes. The overall efficiency $\eta_{tot}$ of a waveguide display system for artificial reality applications may be determined by $\eta_{tot} = \eta_{EQE} \times \eta_{in} \times \eta_{out}$, where $\eta_{EQE}$ is the EQE of each light emitter, $\eta_{in}$ is the in-coupling efficiency of display light from the light emitters into the waveguide, and $\eta_{out}$ is the out-coupling efficiency of the display light from the waveguide towards the user's eye. In general, only a fraction of the emitted light may reach the user's eyes due to, for example, the limited field of view and/or exit pupil of the display system.

Many light emitting devices, such as some semiconductor LEDs, OLEDs, QLEDs, QDEL devices, and PeLEDs, may have an angular emission profile close to the emission profile of a Lambertian emitter. This may reduce the coupling efficiency from the light emitting devices to the eyebox because some emitted light having large emission angles may not be collected and directed to the eyebox by the display optics. This may also cause ghost images due to, for example, stray light from the large emission angles. To improve the light efficiency and image quality of display systems, many display panels may be designed such that the emitted beam of each light emitting device is more directional. For example, a micro-lens array may be used in a display system to collimate the light beams emitted by the light emitting device such that each light beam may have small emission angles. The micro-lenses in the micro-lens array may generally have a plano-convex shape in order to have a positive optical power for collimating or focusing the emitted light beam. Therefore, the top surface of the micro-lens array may not be flat. As such, there may be an air gap between the micro-lens array and another optical component, such as a cover glass, polarizer, or waveplate, which may cause Fresnel reflection at the interface between the micro-lens array and air and Fresnel reflection at the interface between air and another optical component (e.g., the cover glass). Due to the uneven surface of the micro-lens array, it can be difficult to form antireflective coating layers on the micro-lens array to reduce the Fresnel reflection. The plano-convex micro-lenses can also be difficult to fabricate due to the small pitch of the array of light emitting devices (e.g., less than about 20 $\mu$m, less than about 10 $\mu$m, less than about 5 $\mu$m, or less than about 3 $\mu$m), and the fabricated micro-lenses may have defects that may degrade the efficiency and image quality.

In addition, when the emission angles of the light emitting devices in an array of light emitting devices are uniformly controlled (e.g., collimated to have small emission cones and same or similar chief ray angles), light emitted by the light emitting devices may not be uniformly collected and delivered to the eyebox of the display system by display optics (e.g., a pancake lens or another image projecting lens) that may have a limited aperture size and a limited field of view. For example, light emitted by light emitting devices near edges of the array of light emitting devices may be collected and delivered to the eyebox of the display system at lower efficiencies than light emitted by light emitting devices at the center of the array of light emitting devices, which may cause non-uniform intensity or brightness in the displayed images. Therefore, light emitted from light emitting devices at the edges of the array of light emitting devices may need to be deflected differently than light emitted from light emitting devices at the center of the array of light emitting devices. One technique to redirect the emitted light is using a micro-lens array that includes decentered micro-lenses for some light emitting devices. For example, the micro-lens array may have a pitch different from the pitch of the array of light emitting devices or may otherwise be center-offset with respect to the array of light emitting devices, such that the light beam emitted by each light emitting device may not only be collimated or focused, but may also be deflect by a respective angle towards the display optics. This technique may need a precise pixel-level alignment (and thus may be difficult to manufacture), and may have limited deflection angle due to certain geometry limitations. For example, to deflect an emitted light beam by a large angle, the center of the micro-lens in the micro-lens array may need to be offset from the center of the corresponding light emitting device in the array of light emitting devices by a large amount, which may cause crosstalk and/or opposite deflecting due to the small sizes and pitches of the array of light emitting devices and the micro-lens array.

According to certain examples, a polarization diffraction micro-lens array may be used in a near-eye display system to tune the light beams emitted from an array of light emitting devices, such as a two-dimensional array of micro-OLEDs. The polarization diffraction micro-lens array may include, for example, a two-dimensional array of Pancharatnam-Berry Phase (PBP) lenses (also referred to as geometric phase lenses) or polarization volume hologram (PVH) lenses that may be planar and may diffract light of different polarization states in different manners. For example, the polarization diffraction micro-lenses may diffract light of a first polarization state (e.g., right-handed circular polarization (RHCP) or left-handed circular polarization (LHCP)) by a large diffraction angle and at a high diffraction efficiency, and may diffract light of a second polarization state (e.g., LHCP or RHCP) by a different diffraction angle and/or at a low diffraction efficiency. Thus, the polarization diffraction micro-lenses can have different optical powers for light of different polarization states, such as collimating or focusing light in a first circular polarization state while diverging light in a second circular polarization state. The polarization diffraction micro-lens array can be made using birefringent materials such as liquid crystal (LC) polymer layers and thus can be made flat and can be bonded to a cover glass without an air gap in between. The polarization diffraction micro-lens array made of liquid crystal polymer layers can also have an effective refractive index close to or matching the refractive indices of the cover glass, bonding materials (e.g., an optically clear adhesive, such as an epoxy), and/or the array of light emitting devices (e.g., color filters of micro-OLEDs). Therefore, Fresnel reflections at interfaces between different media can be significantly reduced.

In addition, the polarization diffraction micro-lens array can have different phase profiles, such as the phase profile of an on-axis spherical lens, the phase profile of an on-axis freeform lens, the phase profile of an off-axis freeform lens, or a combination, to shape the emission cones of the light beams emitted by different light emitting sources differently, thereby maximizing the light extraction efficiency and overall system efficiency, without physically displacing the polarization diffraction micro-lens array with respect to the array of micro-OLEDs. For example, the polarization diffraction micro-lens array can be center-aligned with the array of light emitting device, rather than being offset from centers of the light emitting devices, while deflecting the light beams emitted by the light emitting devices to different desired directions. Therefore, the crosstalk and/or opposite deflecting associated with plano-convex micro-lenses can be avoided.

The polarization diffraction micro-lenses may be made by coating liquid crystal polymer layers on an alignment layer with alignment patterns formed thereon. The alignment patterns may include alignment patterns for an array of micro-lenses, and may be formed by, for example, polarization interference patterning, direct laser writing patterning, or imprint lithography. The liquid crystal polymer layers may be coated on the patterned surface of the alignment layer, for example, layer by layer, until a desired thickness and/or twist angle is reached. A curing (e.g., UV curing) process may be performed to cure the liquid crystal polymer layers and fix the twist pattern of the liquid crystal molecules. Small polarization diffraction micro-lenses (e.g., with a diameter less than about 20 $\mu$m, less than about 10 $\mu$m, or smaller) with small pitches of the orientation patterns of the liquid crystal molecules (e.g., less than about 1 $\mu$m to less than about 100 nm or lower) for large-angle beam deflection can be made using these fabrication techniques.

The micro-LED devices described herein may be used in conjunction with various technologies, such as an artificial reality system. An artificial reality system, such as a head-mounted display (HMD) or heads-up display (HUD) system, generally includes a display configured to present artificial images that depict objects in a virtual environment. The display may present virtual objects or combine images of real objects with virtual objects, as in virtual reality (VR), augmented reality (AR), or mixed reality (MR) applications. For example, in an AR system, a user may view both displayed images of virtual objects (e.g., computer-generated images (CGIs)) and the surrounding environment by, for example, seeing through transparent display glasses or lenses (often referred to as optical see-through) or viewing displayed images of the surrounding environment captured by a camera (often referred to as video see-through). In some AR systems, the artificial images may be presented to users using an LED-based display subsystem.

As used herein, the term "micro-LED" or "$\mu$LED" may refer to an LED with a linear dimension less than about 200 $\mu$m, such as less than 100 $\mu$m, less than 50 $\mu$m, less than 20 $\mu$m, less than 10 $\mu$m, or smaller. For example, the linear dimension of a micro-LED may be as small as 6 $\mu$m, 5 $\mu$m, 4 $\mu$m, 2 $\mu$m, or smaller. As used herein, a micro-LED may include, for example, a semiconductor micro-LED (e.g., including III-V semiconductor materials) or an organic light emitting material-based micro-LED (e.g., micro-OLED). The disclosure herein is not limited to micro-LEDs, and may also be applied to mini-LEDs and large LEDs.

In the following description, for the purposes of explanation, specific details are set forth in order to provide a thorough understanding of examples of the disclosure. However, it will be apparent that various examples may be practiced without these specific details. For example, devices, systems, structures, assemblies, methods, and other components may be shown as components in block diagram form in order not to obscure the examples in unnecessary detail. In other instances, well-known devices, processes, systems, structures, and techniques may be shown without necessary detail in order to avoid obscuring the examples. The figures and description are not intended to be restrictive. The terms and expressions that have been employed in this disclosure are used as terms of description and not of limitation, and there is no intention in the use of such terms and expressions of excluding any equivalents of the features shown and described or portions thereof. The word "example" is used herein to mean "serving as an example, instance, or illustration." Any embodiment or design described herein as "example" is not necessarily to be construed as preferred or advantageous over other embodiments or designs.

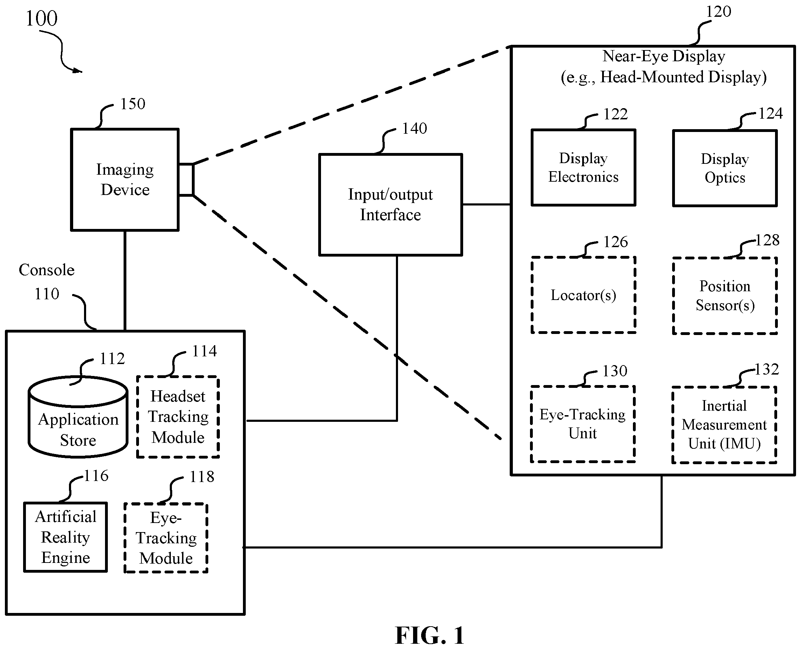

**FIG. 1** is a simplified block diagram of an example of an artificial reality system environment 100 including a near-eye display 120. Artificial reality system environment 100 shown in FIG. 1 may include near-eye display 120, an optional external imaging device 150, and an optional input/output interface 140, each of which may be coupled to an optional console 110. While FIG. 1 shows an example of artificial reality system environment 100 including one near-eye display 120, one external imaging device 150, and one input/output interface 140, any number of these components may be included in artificial reality system environment 100, or any of the components may be omitted. For example, there may be multiple near-eye displays 120 monitored by one or more external imaging devices 150 in communication with console 110. In some configurations, artificial reality system environment 100 may not include external imaging device 150, optional input/output interface 140, and optional console 110. In alternative configurations, different or additional components may be included in artificial reality system environment 100.

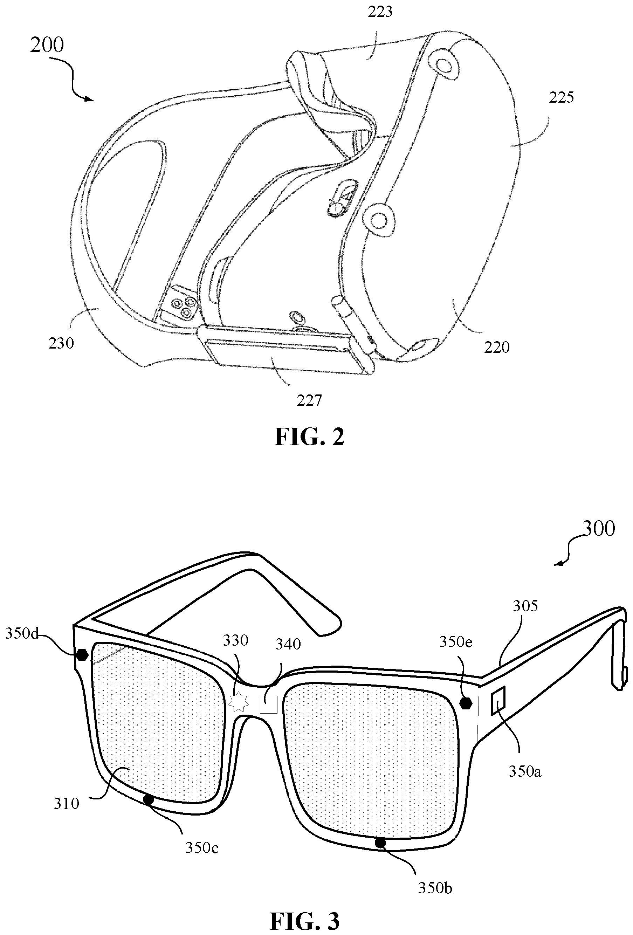

Near-eye display 120 may be a head-mounted display that presents content to a user. Examples of content presented by near-eye display 120 include one or more of images, videos, audio, or any combination thereof. In some examples, audio may be presented via an external device (*e.g.*, speakers and/or headphones) that receives audio information from near-eye display 120, console 110, or both, and presents audio data based on the audio information. Near-eye display 120 may include one or more rigid bodies, which may be rigidly or non-rigidly coupled to each other. A rigid coupling between rigid bodies may cause the coupled rigid bodies to act as a single rigid entity. A non-rigid coupling between rigid bodies may allow the rigid bodies to move relative to each other. In various examples, near-eye display 120 may be implemented in any suitable form-factor, including a pair of glasses. Some examples of near-eye display 120 are further described below with respect to FIGS. 2 and 3. Additionally, in various examples, the functionality described herein may be used in a headset that combines images of an environment external to near-eye display 120 and artificial reality content (*e.g.*, computer-generated images). Therefore, near-eye display 120 may augment images of a physical, real-world environment external to near-eye display 120 with generated content *(e.g.,* images, video, sound, *etc.)* to present an augmented reality to a user.

In various examples, near-eye display 120 may include one or more of display electronics 122, display optics 124, and an eye-tracking unit 130. In some examples, near-eye display 120 may also include one or more locators 126, one or more position sensors 128, and an inertial measurement unit (IMU) 132. Near-eye display 120 may omit any of eye-tracking unit 130, locators 126, position sensors 128, and IMU 132, or include additional elements in various examples. Additionally, in some examples, near-eye display 120 may include elements combining the function of various elements described in conjunction with FIG. 1.

Display electronics 122 may display or facilitate the display of images to the user according to data received from, for example, console 110. In various examples, display electronics 122 may include one or more display panels, such as a liquid crystal display (LCD), an organic light emitting diode (OLED) display, an inorganic light emitting diode (ILED) display, a micro light emitting diode ($\mu$LED) display, an active-matrix OLED display (AMOLED), a transparent OLED display (TOLED), or some other display. For example, in one implementation of near-eye display 120, display electronics 122 may include a front TOLED panel, a rear display panel, and an optical component (*e.g.*, an attenuator, polarizer, or diffractive or spectral film) between the front and rear display panels. Display electronics 122 may include pixels to emit light of a predominant color such as red, green, blue, white, or yellow. In some implementations, display electronics 122 may display a three-dimensional (3D) image through stereoscopic effects produced by two-dimensional panels to create a subjective perception of image depth. For example, display electronics 122 may include a left display and a right display positioned in front of a user's left eye and right eye, respectively. The left and right displays may present copies of an image shifted horizontally relative to each other to create a stereoscopic effect (i.e., a perception of image depth by a user viewing the image).

In certain examples, display optics 124 may display image content optically (*e.g.*, using optical waveguides and couplers) or magnify image light received from display electronics 122, correct optical errors associated with the image light, and present the corrected image light to a user of near-eye display 120. In various examples, display optics 124 may include one or more optical elements, such as, for example, a substrate, optical waveguides, an aperture, a Fresnel lens, a convex lens, a concave lens, a filter, input/output couplers, or any other suitable optical elements that may affect image light emitted from display electronics 122. Display optics 124 may include a combination of different optical elements as well as mechanical couplings to maintain relative spacing and orientation of the optical elements in the combination. One or more optical elements in display optics 124 may have an optical coating, such as an anti-reflective coating, a reflective coating, a filtering coating, or a combination of different optical coatings.

Magnification of the image light by display optics 124 may allow display electronics 122 to be physically smaller, weigh less, and consume less power than larger displays. Additionally, magnification may increase a field of view of the displayed content. The amount of magnification of image light by display optics 124 may be changed by adjusting, adding, or removing optical elements from display optics 124. In some examples, display optics 124 may project displayed images to one or more image planes that may be further away from the user's eyes than near-eye display 120.

Display optics 124 may also be designed to correct one or more types of optical errors, such as two-dimensional optical errors, three-dimensional optical errors, or any combination thereof. Two-dimensional errors may include optical aberrations that occur in two dimensions. Example types of two-dimensional errors may include barrel distortion, pincushion distortion, longitudinal chromatic aberration, and transverse chromatic aberration. Three-dimensional errors may include optical errors that occur in three dimensions. Example types of three-dimensional errors may include spherical aberration, comatic aberration, field curvature, and astigmatism.

Locators 126 may be objects located in specific positions on near-eye display 120 relative to one another and relative to a reference point on near-eye display 120. In some implementations, console 110 may identify locators 126 in images captured by external imaging device 150 to determine the artificial reality headset's position, orientation, or both. A locator 126 may be an LED, a corner cube reflector, a reflective marker, a type of light source that contrasts with an environment in which near-eye display 120 operates, or any combination thereof. In examples where locators 126 are active components (*e.g.*, LEDs or other types of light emitting devices), locators 126 may emit light in the visible band (*e.g.*, about 380 nm to 750 nm), in the infrared (IR) band (*e.g.,* about 750 nm to 1 mm), in the ultraviolet band (*e.g.,* about 10 nm to about 380 nm), in another portion of the electromagnetic spectrum, or in any combination of portions of the electromagnetic spectrum.

External imaging device 150 may include one or more cameras, one or more video cameras, any other device capable of capturing images including one or more of locators 126, or any combination thereof. Additionally, external imaging device 150 may include one or more filters (*e.g.,* to increase signal to noise ratio). External imaging device 150 may be configured to detect light emitted or reflected from locators 126 in a field of view of external imaging device 150. In examples where locators 126 include passive elements (*e.g.*, retroreflectors), external imaging device 150 may include a light source that illuminates some or all of locators 126, which may retro-reflect the light to the light source in external imaging device 150. Slow calibration data may be communicated from external imaging device 150 to console 110, and external imaging device 150 may receive one or more calibration parameters from console 110 to adjust one or more imaging parameters (*e.g.*, focal length, focus, frame rate, sensor temperature, shutter speed, aperture, *etc*.).

Position sensors 128 may generate one or more measurement signals in response to motion of near-eye display 120. Examples of position sensors 128 may include accelerometers, gyroscopes, magnetometers, other motion-detecting or error-correcting sensors, or any combination thereof. For example, position sensors 128 may include multiple accelerometers to measure translational motion (*e.g.*, forward/back, up/down, or left/right) and multiple gyroscopes to measure rotational motion (*e.g.*, pitch, yaw, or roll). In some examples, various position sensors may be oriented orthogonally to each other.

IMU 132 may be an electronic device that generates fast calibration data based on measurement signals received from one or more of position sensors 128. Position sensors 128 may be located external to IMU 132, internal to IMU 132, or any combination thereof. Based on the one or more measurement signals from one or more position sensors 128, IMU 132 may generate fast calibration data indicating an estimated position of near-eye display 120 relative to an initial position of near-eye display 120. For example, IMU 132 may integrate measurement signals received from accelerometers over time to estimate a velocity vector and integrate the velocity vector over time to determine an estimated position of a reference point on near-eye display 120. Alternatively, IMU 132 may provide the sampled measurement signals to console 110, which may determine the fast calibration data. While the reference point may generally be defined as a point in space, in various examples, the reference point may also be defined as a point within near-eye display 120 (*e.g.*, a center of IMU 132).

Eye-tracking unit 130 may include one or more eye-tracking systems. Eye tracking may refer to determining an eye's position, including orientation and location of the eye, relative to near-eye display 120. An eye-tracking system may include an imaging system to image one or more eyes and may optionally include a light emitter, which may generate light that is directed to an eye such that light reflected by the eye may be captured by the imaging system. For example, eye-tracking unit 130 may include a non-coherent or coherent light source (*e.g.,* a laser diode) emitting light in the visible spectrum or infrared spectrum, and a camera capturing the light reflected by the user's eye. As another example, eye-tracking unit 130 may capture reflected radio waves emitted by a miniature radar unit. Eye-tracking unit 130 may use low-power light emitters that emit light at frequencies and intensities that would not injure the eye or cause physical discomfort. Eye-tracking unit 130 may be arranged to increase contrast in images of an eye captured by eye-tracking unit 130 while reducing the overall power consumed by eye-tracking unit 130 (*e.g.,* reducing power consumed by a light emitter and an imaging system included in eye-tracking unit 130). For example, in some implementations, eye-tracking unit 130 may consume less than 100 milliwatts of power.

Near-eye display 120 may use the orientation of the eye to, *e.g.*, determine an inter-pupillary distance (IPD) of the user, determine gaze direction, introduce depth cues (*e.g.,* blur image outside of the user's main line of sight), collect heuristics on the user interaction in the VR media (*e.g.*, time spent on any particular subject, object, or frame as a function of exposed stimuli), some other functions that are based in part on the orientation of at least one of the user's eyes, or any combination thereof. Because the orientation may be determined for both eyes of the user, eye-tracking unit 130 may be able to determine where the user is looking. For example, determining a direction of a user's gaze may include determining a point of convergence based on the determined orientations of the user's left and right eyes. A point of convergence may be the point where the two foveal axes of the user's eyes intersect. The direction of the user's gaze may be the direction of a line passing through the point of convergence and the mid-point between the pupils of the user's eyes.

Input/output interface 140 may be a device that allows a user to send action requests to console 110. An action request may be a request to perform a particular action. For example, an action request may be to start or to end an application or to perform a particular action within the application. Input/output interface 140 may include one or more input devices. Example input devices may include a keyboard, a mouse, a game controller, a glove, a button, a touch screen, or any other suitable device for receiving action requests and communicating the received action requests to console 110. An action request received by the input/output interface 140 may be communicated to console 110, which may perform an action corresponding to the requested action. In some examples, input/output interface 140 may provide haptic feedback to the user in accordance with instructions received from console 110. For example, input/output interface 140 may provide haptic feedback when an action request is received, or when console 110 has performed a requested action and communicates instructions to input/output interface 140. In some examples, external imaging device 150 may be used to track input/output interface 140, such as tracking the location or position of a controller (which may include, for example, an IR light source) or a hand of the user to determine the motion of the user. In some examples, near-eye display 120 may include one or more imaging devices to track input/output interface 140, such as tracking the location or position of a controller or a hand of the user to determine the motion of the user.

Console 110 may provide content to near-eye display 120 for presentation to the user in accordance with information received from one or more of external imaging device 150, near-eye display 120, and input/output interface 140. In the example shown in FIG. 1, console 110 may include an application store 112, a headset tracking module 114, an artificial reality engine 116, and an eye-tracking module 118. Some examples of console 110 may include different or additional modules than those described in conjunction with FIG. 1. Functions further described below may be distributed among components of console 110 in a different manner than is described here.

In some examples, console 110 may include a processor and a non-transitory computer-readable storage medium storing instructions executable by the processor. The processor may include multiple processing units executing instructions in parallel. The non-transitory computer-readable storage medium may be any memory, such as a hard disk drive, a removable memory, or a solid-state drive (e.g., flash memory or dynamic random access memory (DRAM)). In various examples, the modules of console 110 described in conjunction with FIG. 1 may be encoded as instructions in the non-transitory computer-readable storage medium that, when executed by the processor, cause the processor to perform the functions further described below.

Application store 112 may store one or more applications for execution by console 110. An application may include a group of instructions that, when executed by a processor, generates content for presentation to the user. Content generated by an application may be in response to inputs received from the user via movement of the user's eyes or inputs received from the input/output interface 140. Examples of the applications may include gaming applications, conferencing applications, video playback application, or other suitable applications.

Headset tracking module 114 may track movements of near-eye display 120 using slow calibration information from external imaging device 150. For example, headset tracking module 114 may determine positions of a reference point of near-eye display 120 using observed locators from the slow calibration information and a model of near-eye display 120. Headset tracking module 114 may also determine positions of a reference point of near-eye display 120 using position information from the fast calibration information. Additionally, in some examples, headset tracking module 114 may use portions of the fast calibration information, the slow calibration information, or any combination thereof, to predict a future location of near-eye display 120. Headset tracking module 114 may provide the estimated or predicted future position of near-eye display 120 to artificial reality engine 116.

Artificial reality engine 116 may execute applications within artificial reality system environment 100 and receive position information of near-eye display 120, acceleration information of near-eye display 120, velocity information of near-eye display 120, predicted future positions of near-eye display 120, or any combination thereof from headset tracking module 114. Artificial reality engine 116 may also receive estimated eye position and orientation information from eye-tracking module 118. Based on the received information, artificial reality engine 116 may determine content to provide to near-eye display 120 for presentation to the user. For example, if the received information indicates that the user has looked to the left, artificial reality engine 116 may generate content for near-eye display 120 that mirrors the user's eye movement in a virtual environment. Additionally, artificial reality engine 116 may perform an action within an application executing on console 110 in response to an action request received from input/output interface 140, and provide feedback to the user indicating that the action has been performed. The feedback may be visual or audible feedback via near-eye display 120 or haptic feedback via input/output interface 140.

Eye-tracking module 118 may receive eye-tracking data from eye-tracking unit 130 and determine the position of the user's eye based on the eye tracking data. The position of the eye may include an eye's orientation, location, or both relative to near-eye display 120 or any element thereof. Because the eye's axes of rotation change as a function of the eye's location in its socket, determining the eye's location in its socket may allow eye-tracking module 118 to determine the eye's orientation more accurately.

FIG. 2 is a perspective view of an example of a near-eye display in the form of an HMD device 200 for implementing some of the examples disclosed herein. HMD device 200 may be a part of, e.g., a VR system, an AR system, an MR system, or any combination thereof. HMD device 200 may include a body 220 and a head strap 230. FIG. 2 shows a bottom side 223, a front side 225, and a left side 227 of body 220 in the perspective view. Head strap 230 may have an adjustable or extendible length. There may be a sufficient space between body 220 and head strap 230 of HMD device 200 for allowing a user to mount HMD device 200 onto the user's head. In various examples, HMD device 200 may include additional, fewer, or different components. For example, HMD device 200 may include eyeglass temples and temple tips as shown in, for example, FIG. 3 below, rather than head strap 230.

HMD device 200 may present to a user media including virtual and/or augmented views of a physical, real-world environment with computer-generated elements. Examples of the media presented by HMD device 200 may include images (e.g., two-dimensional (2D) or three-dimensional (3D) images), videos (e.g., 2D or 3D videos), audio, or any combination thereof. The images and videos may be presented to each eye of the user by one or more display assemblies (not shown in FIG. 2) enclosed in body 220 of HMD device 200. In various examples, the one or more display assemblies may include a single electronic display panel or multiple electronic display panels (*e.g.*, one display panel for each eye of the user). Examples of the electronic display panel(s) may include, for example, an LCD, an OLED display, an ILED display, a µLED display, an AMOLED, a TOLED, some other display, or any combination thereof. HMD device 200 may include two eye box regions.

In some implementations, HMD device 200 may include various sensors (not shown), such as depth sensors, motion sensors, position sensors, and eye tracking sensors. Some of these sensors may use a structured light pattern for sensing. In some implementations, HMD device 200 may include an input/output interface for communicating with a console. In some implementations, HMD device 200 may include a virtual reality engine (not shown) that can execute applications within HMD device 200 and receive depth information, position information, acceleration information, velocity information, predicted future positions, or any combination thereof of HMD device 200 from the various sensors. In some implementations, the information received by the virtual reality engine may be used for producing a signal (*e.g.,* display instructions) to the one or more display assemblies. In some implementations, HMD device 200 may include locators (not shown, such as locators 126) located in fixed positions on body 220 relative to one another and relative to a reference point. Each of the locators may emit light that is detectable by an external imaging device.

**FIG. 3** is a perspective view of an example of a near-eye display 300 in the form of a pair of glasses for implementing some of the examples disclosed herein. Near-eye display 300 may be a specific implementation of near-eye display 120 of FIG. 1, and may be configured to operate as a virtual reality display, an augmented reality display, and/or a mixed reality display. Near-eye display 300 may include a frame 305 and a display 310. Display 310 may be configured to present content to a user. In some examples, display 310 may include display electronics and/or display optics. For example, as described above with respect to near-eye display 120 of FIG. 1, display 310 may include an LCD display panel, an LED display panel, or an optical display panel (*e.g.,* a waveguide display assembly).

Near-eye display 300 may further include various sensors 350a, 350b, 350c, 350d, and 350e on or within frame 305. In some examples, sensors 350a-350e may include one or more depth sensors, motion sensors, position sensors, inertial sensors, or ambient light sensors. In some examples, sensors 350a-350e may include one or more image sensors configured to generate image data representing different fields of views in different directions. In some examples, sensors 350a-350e may be used as input devices to control or influence the displayed content of near-eye display 300, and/or to provide an interactive VR/AR/MR experience to a user of near-eye display 300. In some examples, sensors 350a-350e may also be used for stereoscopic imaging.

In some examples, near-eye display 300 may further include one or more illuminators 330 to project light into the physical environment. The projected light may be associated with different frequency bands (*e.g.,* visible light, infra-red light, ultra-violet light, *etc*.), and may serve various purposes. For example, illuminator(s) 330 may project light in a dark environment (or in an environment with low intensity of infra-red light, ultra-violet light, *etc.*) to assist sensors 350a-350e in capturing images of different objects within the dark environment. In some examples, illuminator(s) 330 may be used to project certain light patterns onto the objects within the environment. In some examples, illuminator(s) 330 may be used as locators, such as locators 126 described above with respect to FIG. 1.

In some examples, near-eye display 300 may also include a high-resolution camera 340. Camera 340 may capture images of the physical environment in the field of view. The captured images may be processed, for example, by a virtual reality engine (*e.g.*, artificial reality engine 116 of FIG. 1) to add virtual objects to the captured images or modify physical objects in the captured images, and the processed images may be displayed to the user by display 310 for AR or MR applications.

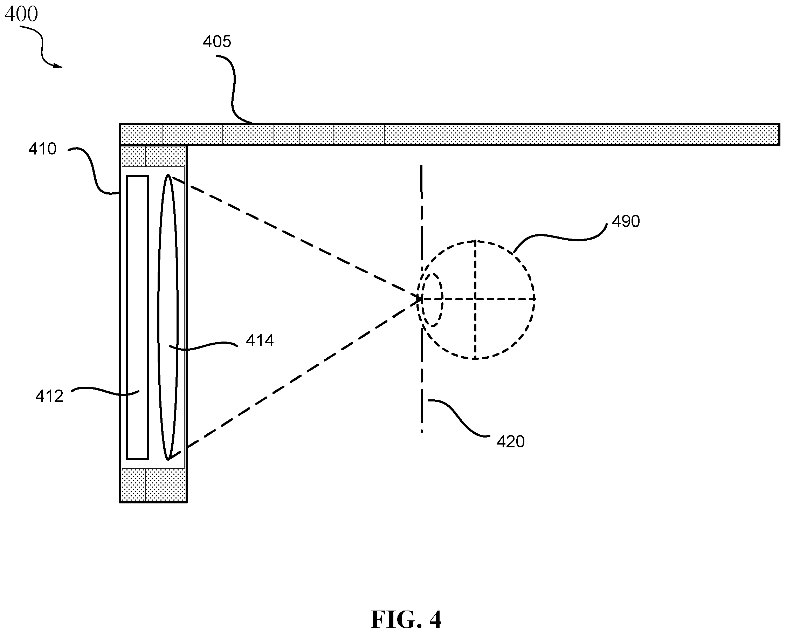

**FIG. 4** is a cross-sectional view of an example of a near-eye display 400. Near-eye display 400 may include at least one display assembly 410. Display assembly 410 may be configured to direct image light (e.g., display light) to an eyebox located at an exit pupil 420 and to user's eye 490. It is noted that, even though FIG. 4 and other figures in the present disclosure show an eye of a user of the near-eye display for illustration purposes, the eye of the user is not a part of the corresponding near-eye display.

As HMD device 200 and near-eye display 300, near-eye display 400 may include a frame 405 and display assembly 410 that may include a display 412 and/or display optics 414 coupled to or embedded in frame 405. As described above, display 412 may display images to the user electrically (e.g., using LCDs, LEDs, OLEDs) or optically (e.g., using a waveguide display and optical couplers) according to data received from a processing unit, such as console 110. In some examples, display 412 may include a display panel that includes pixels made of LCDs, LEDs, OLEDs, and the like. Display 412 may include sub-pixels to emit light of a predominant color, such as red, green, blue, white, or yellow. In some examples, display assembly 410 may include a stack of one or more waveguide displays including, but not restricted to, a stacked waveguide display, a varifocal waveguide display, and the like. The stacked waveguide display may be a polychromatic display (e.g., a red-green-blue (RGB) display) created by stacking waveguide displays whose respective monochromatic sources are of different colors.

Display optics 414 may be similar to display optics 124 and may display image content optically (e.g., using optical waveguides and optical couplers), correct optical errors associated with the image light, combine images of virtual objects and real objects, and present the corrected image light to exit pupil 420 of near-eye display 400, where the user's eye 490 may be located. In some examples, display optics 414 may also relay the images to create virtual images that appear to be away from display 412 and further than just a few centimeters away from the eyes of the user. For example, display optics 414 may collimate the image source to create a virtual image that may appear to be far away (e.g., greater than about 0.3 m, such as about 0.5 m, 1m, or 3 m away) and convert spatial information of the displayed virtual objects into angular information. In some examples, display optics 414 may also magnify the source image to make the image appear larger than the actual size of the source image. More details of display 412 and display optics 414 are described below.

In various implementations, the optical system of a near-eye display, such as an HMD, may be pupil-forming or non-pupil-forming. Non-pupil-forming HMDs may not use intermediary optics to relay the displayed image, and thus the user's pupils may serve as the pupils of the HMD. Such non-pupil-forming displays may be variations of a magnifier (sometimes referred to as "simple eyepiece"), which may magnify a displayed image to form a virtual image at a greater distance from the eye. The non-pupil-forming display may use fewer optical elements. Pupil-forming HMDs may use optics similar to, for example, optics of a compound microscope or telescope, and may include some forms of projection optics that magnify an image and relay it to the exit pupil.

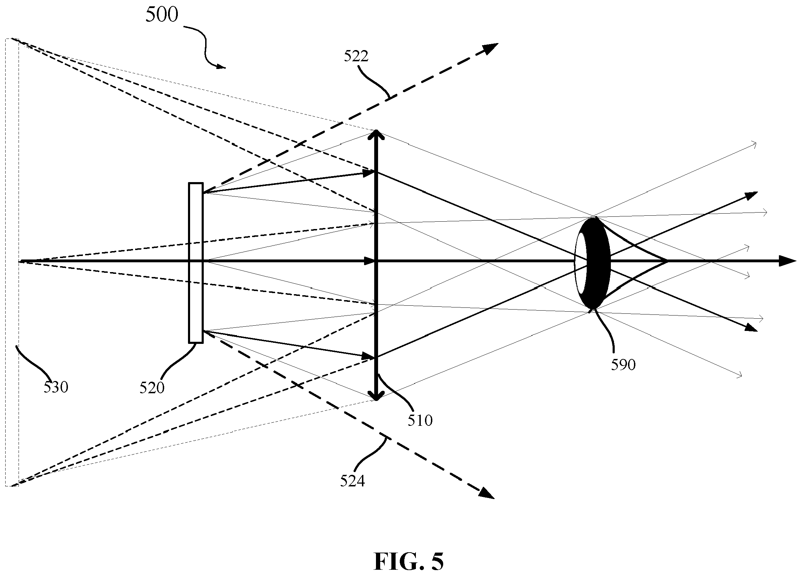

**FIG. 5** illustrates an example of an optical system 500 with a non-pupil forming configuration for a near-eye display device. Optical system 500 may be an example of near-eye display 400, and may include display optics 510 and an image source 520 (e.g., a display panel). Display optics 510 may function as a magnifier. FIG. 5 shows that image source 520 is in front of display optics 510. In some other examples, image source 520 may be located outside of the field of view of the user's eye 590. For example, one or more deflectors or directional couplers may be used to deflect light from an image source to make the image source appear to be at the location of image source 520 shown in FIG. 5. Image source 520 may be an example of display 412 described above. For example, image source 520 may include a two-dimensional array of light emitters, such as semiconductor micro-LEDs or micro-OLEDs. The dimensions and pitches of the light emitters in image source 520 may be small. For example, each light emitter may have a diameter less than 2 $\mu$m (e.g., about 1.2 $\mu$m) and the pitch may be less than 2 $\mu$m (e.g., about 1.5 $\mu$m). As such, the number of light emitters in image source 520 can be equal to or greater than the number of pixels in a display image, such as 960×720, 1280×720, 1440×1080, 1920×1080, 2160×1080, or 2560×1080 pixels. Thus, a display image may be generated simultaneously by image source 520.

Light from an area (e.g., a pixel or a light emitter) of image source 520 may be directed to a user's eye 590 by display optics 510. Light directed by display optics 510 may form virtual images on an image plane 530. The location of image plane 530 may be determined based on the location of image source 520 and the focal length of display optics 510. A user's eye 590 may form a real image on the retina of user's eye 590 using light directed by display optics 510. In this way, objects at different spatial locations on image source 520 may appear to be objects on an image plane far away from user's eye 590 at different viewing angles. Image source 520 may have a size larger or smaller than the size (e.g., aperture) of display optics 510. Some light emitted from image source 520 with large emission angles (as shown by light rays 522 and 524) may not be collected and directed to user's eye 590 by display optics 510, and may become stray light.

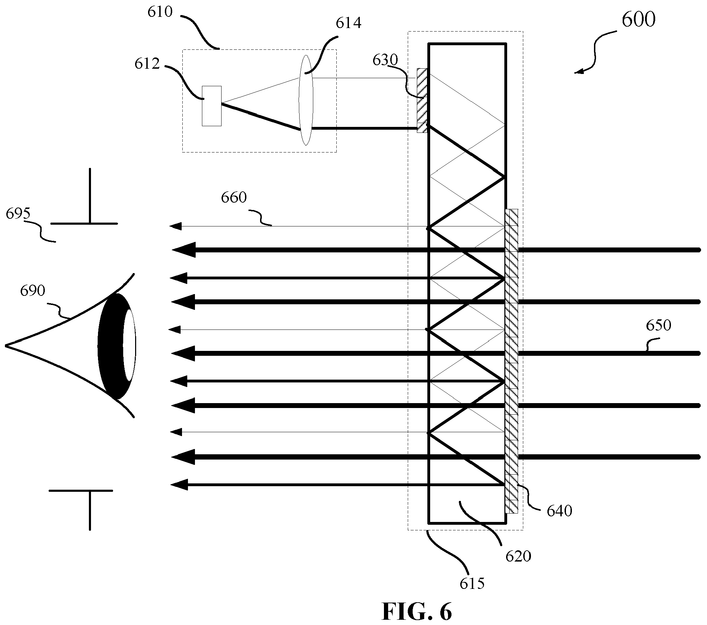

**FIG. 6** illustrates an example of an optical see-through augmented reality system 600 including a waveguide display. Augmented reality system 600 may be another example of near-eye display 400, and may include a projector 610 and a combiner 615. Projector 610 may include a light source or image source 612 and projector optics 614. In some examples, image source 612 may include a plurality of pixels that displays virtual objects, such as an LCD display panel or an LED display panel. For example, light source or image source 612 may include one or more micro-LED devices, such as micro-OLED devices or semiconductor micro-LED devices. In some examples, image source 612 may include a plurality of light sources (*e.g.*, a two-dimensional array of micro-LEDs), each emitting a monochromatic image light corresponding to a primary color (*e.g.,* red, green, or blue). In some examples, image source 612 may include three two-dimensional arrays of micro-LEDs, where each two-dimensional array of micro-LEDs may include micro-LEDs configured to emit light of a primary color (*e.g.,* red, green, or blue). In some examples, image source 612 may include a coherent or partially coherent light source (e.g., a laser) and an optical pattern generator, such as a spatial light modulator.

Projector optics 614 may include one or more optical components that can condition the light from image source 612, such as expanding, collimating, scanning, or projecting light from image source 612 to combiner 615. The one or more optical components may include, for example, one or more solid lenses, liquid lenses, mirrors, apertures, and/or gratings. In some examples, image source 612 may include one or more two-dimensional arrays of micro-LEDs, and projector optics 614 may include a lens assembly. In some examples, image source 612 may include one or more one-dimensional arrays or elongated two-dimensional arrays of micro-LEDs, and projector optics 614 may include one or more one-dimensional scanners (*e.g.*, micro-mirrors or prisms) configured to scan light emitted by the one-dimensional arrays or elongated two-dimensional arrays of micro-LEDs to generate image frames. In some examples, projector optics 614 may include a liquid lens (*e.g.,* a liquid crystal lens) with a plurality of electrodes that allows scanning of light from image source 612.

Combiner 615 may include an input coupler 630 for coupling light from projector 610 into a substrate 620 of combiner 615. Input coupler 630 may include, for example, a diffractive optical element (DOE) (*e.g.,* a volume holographic grating, a surface-relief grating, a PBP grating, or a PVH grating), a slanted surface of substrate 620, or a refractive coupler (*e.g.,* a wedge or a prism). For example, input coupler 630 may include a transmissive volume Bragg grating (e.g., on a surface of substrate 620 facing projector 610) or a reflective volume Bragg grating (e.g., on a surface of substrate 620 opposing projector 610). Input coupler 630 may have a coupling efficiency of greater than 30%, 50%, 75%, 90%, or higher for visible light. Light coupled into substrate 620 may propagate within substrate 620 through, for example, total internal reflection (TIR). In some examples, substrate 620 may be in the form of a lens of a pair of eyeglasses. Substrate 620 may have a flat or a curved surface, and may include one or more types of dielectric materials, such as glass, quartz, plastic, polymer, poly(methyl methacrylate) (PMMA), crystal, or ceramic. A thickness of the substrate may range from, for example, less than about 1 mm to about 10 mm or more. Substrate 620 may be transparent to visible light.

Substrate 620 may include or may be coupled to a plurality of output couplers 640. Each output coupler 640 may be configured to extract at least a portion of the light guided by and propagating within substrate 620 out of substrate 620, and direct the extracted light 660 towards an eyebox 695 where an eye 690 of the user of augmented reality system 600 may be located when augmented reality system 600 is in use. The plurality of output couplers 640 may replicate the exit pupil to increase the size of eyebox 695 such that the displayed image may be visible in a larger area. As input coupler 630, output couplers 640 may include grating couplers (e.g., volume holographic gratings or surface-relief gratings), other diffraction optical elements (DOEs), prisms, partial reflectors (e.g., transflective mirrors), and the like. For example, output couplers 640 may include reflective volume Bragg gratings, transmissive volume Bragg gratings, or PVHs. Output couplers 640 may have different coupling (*e.g.,* diffraction) efficiencies at different locations such that the intensities of the light beams coupled out of substrate 620 at different locations may be about the same. Substrate 620 and output couplers 640 may also allow light 650 from the environment in front of combiner 615 to pass through with little or no loss. For example, in some implementations, output couplers 640 may have a very low diffraction efficiency for light 650 such that light 650 may be refracted or otherwise pass through output couplers 640 with little loss, and may have a higher intensity than extracted light 660. As a result, the user may be able to view combined images of the environment in front of combiner 615 and images of virtual objects projected by projector 610.

The overall efficiency of a near-eye display, such as near-eye display 400, optical system 500, and waveguide-based augmented reality system 600, may be a product of the efficiency of individual components and may also depend on how the components are connected or arranged. For example, the overall efficiency $\eta_{tot}$ of the near-eye display of FIG. 5 may depend on the light emitting efficiency of image source 520, and the efficiency of coupling light from image source 520 to user's eye 590 by display optics 510. The overall efficiency $\eta_{tot}$ of the waveguide-based display in augmented reality system 600 may depend on the light emitting efficiency of image source 612, the light coupling efficiency from image source 612 into combiner 615 by projector optics 614 and input coupler 630, and the output coupling efficiency of output coupler 640, and thus may be determined by:

$$\eta_{tot} = \eta_{EQE} \times \eta_{in} \times \eta_{out},$$

where $\eta_{EQE}$ is the external quantum efficiency of image source 612, $\eta_{in}$ is the in-coupling efficiency of light from image source 612 into the waveguide (*e.g.,* substrate 620), and $\eta_{out}$ is the outcoupling efficiency of light from the waveguide towards the user's eye by output coupler 640. Thus, the overall efficiency $\eta_{tot}$ of the waveguide-based display can be improved by improving one or more of $\eta_{EQE}$, $\eta_{in}$, and $\eta_{out}$

The external quantum efficiency may be affected by the efficiency of extracting light from the image source. For example, at the light emitting surface of the image source (e.g., the interface between image source and air), light with incidence angles greater than the critical angle for total internal reflection may be reflected back to the image source, and thus only a portion of the light generated by the image source may exit the image source. The light coupling efficiency from the image source to user's eyes by the display optics may be affected by the beam profile of the light beam emitted by the image source. For example, for a display system with a limited acceptance angle (*e.g.,* with a half-width half-magnitude (HWHM) angle less than 20°), if the light beam emitted by a light emitter (*e.g.,* micro-LED) has a wide beam profile (*e.g.,* a Lambertian emission profile), only a small fraction of the total light emitted by the light emitter may be captured by the display optics and delivered to the user's eyes. In some examples, to improve the efficiency of extracting light from the light source (and thus the external quantum efficiency) and the efficiency of coupling extracted light to user's eye, a micro-lens array may be used to reduce the total internal reflection at the light emitting surface, and modify the beam profiles of (e.g., collimating) the light beams emitted by the array of light emitters.

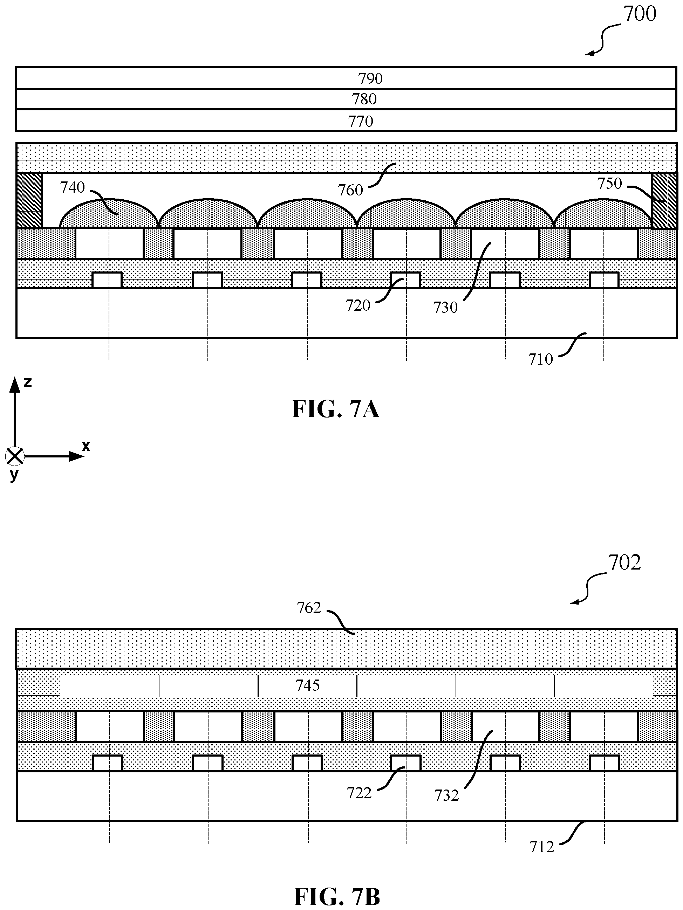

FIG. 7A illustrates an example of a micro-OLED display system 700. In the illustrated example, micro-OLED display system 700 may include a driving layer 710, an OLED layer 720, a color filter layer 730, a micro-lens array 740, a cover glass 760, and spacers 750 that separate cover glass 760 from micro-lens array 740. Driving layer 710 may include, for example, a complementary metal-oxide-semiconductor (CMOS) backplane including pixel drive circuits fabricated thereon, and/or thin-film transistor (TFT) circuits on a glass substrate. OLED layer 720 may include a two-dimensional array of white-light emitting micro-OLEDs controlled by the pixel drive circuits on driving layer 710. Each micro-OLED in OLED layer 720 may include, for example, a bottom electrode (e.g., a cathode including a metal layer, such as Al or Ag), an electron transport layer, an organic light emitting layer, a hole transport layer, and a top electrode (e.g., an anode including an indium tin oxide (ITO) layer). Color filter layer 730 may include an array of color filters that include red, green, and blue color filters arranged according to a certain pattern, and may convert the white light emitted by the micro-OLEDs into red, green, and blue light. In some examples, OLED layer 720 may include an array of micro-OLEDs that can directly emit red, green, and blue light, and thus color filter layer 730 may not be used.

Micro-lens array 740 may include an array (e.g., a two-dimensional array) of convex lenses fabricated in a transparent material layer (e.g., an oxide layer such as a $SiO_2$ substrate) and may be bonded to color filter layer 730. Each micro-lens in micro-lens array 740 may be aligned with a corresponding micro-OLED and/or a corresponding color filter. The micro-lens may reduce the light reflection (e.g., caused by total internal reflection) at the light emitting surface of the corresponding micro-LED and/or color filter, and thus may increase the light extraction efficiency from the micro-LED and/or color filter. The micro-lens may also collimate the light emitted from the micro-LED and/or color filter, such that the emitted light beam may have small emission angles (e.g., within $\pm 18.5°$, such as close to about 0°, with respect to the z direction).

Cover glass 760 may include a transparent substrate (e.g., including glass or quartz) that may protect micro-lens array 740, color filter layer 730, and/or OLED layer 720. In some examples, micro-OLED display system 700 may also include a circular polarizer attached to cover glass 760 through a bonding layer or spacers. The circular polarizer may block, for example, ambient light reflected from the bottom electrodes of the micro-LEDs and/or the interface between air and micro-lens array 740. In the illustrated example, micro-OLED display system 700 may include a first quarter waveplate (QWP) 770, a linear polarizer 780, and a second QWP 790, where linear polarizer 780 and QWP 770 or 790 may form a circular polarizer that can block reflected light. For example, linear polarizer 780 may allow ambient light with a first linear polarization direction to pass through. QWP 770 may convert the linearly polarized light into circularly polarized light, such as right-handed circularly polarized light. The right-handed circularly polarized light may be reflected by a reflective surface (e.g., the bottom electrode of a micro-OLED) into left-handed circularly polarized light. QWP 770 may convert the reflected left-handed circularly polarized light into linearly polarized light with a second linearly polarization direction that is orthogonal to the first linear polarization direction. The linearly polarized light with the second linearly polarization direction may be blocked by linear polarizer 780.

To form the convex lenses, the medium adjacent to micro-lens array 740 may need to have a refractive index lower than the refractive index of micro-lens array 740. In the example shown in FIG. 7A, spacers 750 may be used to form an air gap between micro-lens array 740 and cover glass 760, such that micro-lens array 740 may include convex lenses to collimate light emitted from the micro-OLED and/or the color filter. Due to the low-refractive index intermediate medium (e.g., air) between micro-lens array 740 and cover glass 760, there may be Fresnel reflection at the interface between micro-lens array 740 and air and Fresnel reflection at the interface between air and cover glass 760. The Fresnel reflection at each interface may be a function of the incident angle and the refractive indices of the two media, and may be, for example, close to about 4%. Thus, there may be a total about 8% loss due to Fresnel reflections at the two interfaces. The Fresnel reflection at the interface between air and cover glass 760 may be reduced by coating cover glass 760 with antireflective coating layers. However, due to the uneven surface of micro-lens array 740, it can be difficult to form antireflective coating layers on micro-lens array 740 to reduce the Fresnel reflection at the interface between micro-lens array 740 and air. In addition, when the pitch of the array of micro-OLEDs is small, such as less than about 20 $\mu$m, less than about 10 $\mu$m, less than about 5 $\mu$m, or less than about 3 $\mu$m, it may be difficult to fabricate the small micro-lenses in micro-lens array 740 and align micro-lens array 740 with color filters in color filter layer 730 and micro-OLEDs in OLED layer 720. The fabricated micro-lenses may have more defects that may degrade the efficiency and image quality.

According to certain examples, a polarization diffraction micro-lens array may be used in a near-eye display system to tune the light beams emitted from an array of light emitting devices, such as a two-dimensional array of micro-OLEDs. The polarization diffraction micro-lens array may include, for example, a two-dimensional array of PBP lenses or PVH lenses that may be planar and may diffract light of different polarization states in different manners. For example, the polarization diffraction micro-lenses may diffract light of a first polarization state (e.g., RHCP or LHCP) by a large diffraction angle and at a high diffraction efficiency into a first (e.g., +1st) diffraction order, and may diffract light of a second polarization state (e.g., LHCP or RHCP) by a different diffraction angle and at a high or low diffraction efficiency into another (e.g., -1st or 0th) diffraction order. Thus, the polarization diffraction micro-lenses may have different optical powers for light of different polarization states, such as collimating or focusing light in a first circular polarization state while diverging light in a second circular polarization state. The polarization diffraction micro-lens array can be made using birefringent materials such as liquid crystal polymer layers, and thus can be made flat and can be bonded to a cover glass without an air gap in between. The polarization diffraction lens array made of liquid crystal polymer layers can also have an effective refractive index (e.g., between about 1.5-1.7) close to or matching the refractive indices of the cover glass, bonding materials (e.g., an optically clear adhesive, such as an epoxy), and/or the array of micro-OLEDs (e.g., color filters of the micro-OLEDs). Therefore, Fresnel reflections at interfaces between different media can be significantly reduced.

**FIG. 7B** illustrates an example of a micro-OLED display system 702 including polarization diffraction micro-lenses for light extraction and beam collimation. In the illustrated example, micro-OLED display system 702 may include a driving layer 712, an OLED layer 722, a color filter layer 732, a polarization diffraction micro-lens array 745, and a cover glass 762. Driving layer 712, OLED layer 722, color filter layer 732, and cover glass 762 may be similar to driving layer 710, OLED layer 720, color filter layer 730, and cover glass 760, respectively. Polarization diffraction micro-lens array 745 may include flat lenses, such as a PBP or PVH micro-lens array made of birefringent materials such as liquid crystal polymer layers, as described in more details below. Polarization diffraction micro-lens array 745 may be bonded to OLED layer 722 or color filter layer 732 using, for example, an optically clear adhesive, such as an epoxy.

In some examples, the polarization diffraction micro-lenses may be made by coating liquid crystal polymer layers on an alignment layer with alignment patterns formed thereon. The alignment patterns may include alignment patterns for an array of micro-lenses, and may be formed by, for example, polarization interference patterning, direct laser writing patterning, or imprint lithography. The liquid crystal polymer layers may be coated on the patterned surface of the alignment layer, for example, layer by layer, until a desired thickness and/or twist angle is reached. A curing (e.g., UV curing) process may be performed to cure the liquid crystal polymer layers and fix the twist pattern of the liquid crystal molecules. Small polarization diffraction micro-lenses (e.g., with a diameter less than about 20 $\mu$m, less than about 10 $\mu$m, or smaller) with small pitches of the orientation patterns of the liquid crystal molecules (e.g., less than about 1 $\mu$m to less than about 100 nm or lower) for large-angle beam deflection can be made using these fabrication techniques

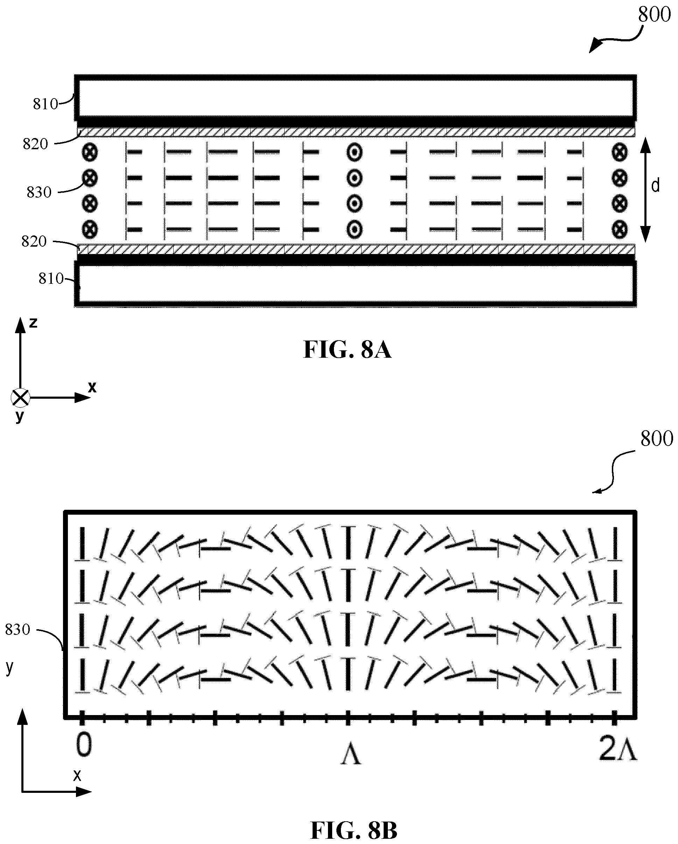

**FIG. 8A** is a view of an x-z plane of an example of a PBP grating 800. **FIG. 8B** is a view of an x-y plane of the example of PBP grating 800 shown in FIG. 8A. In the illustrated example, PBP grating 800 may include a pair of substrates 810, one or two surface alignment layers 820, and a liquid crystal layer 830. Substrates 810 may be transparent to visible light. Surface alignment layer(s) 820 may have a predefined surface pattern, such that liquid crystal molecules in liquid crystal layer 830 may self-align according to the predefined surface pattern. In some examples, PBP grating 800 may include one substrate and a cured film attached to the substrate, or may include a freestanding film that does not need to be attached to a substrate.

As illustrated, liquid crystal layer 830 in PBP grating 800 may include liquid crystal molecules that are oriented in a repetitive rotational pattern in the x-y plane when viewed in the light propagation direction (*e.g.,* z direction). The repetitive rotational pattern may be created by, for example, recording the interference pattern of two orthogonally circular-polarized laser beams in a polarization-sensitive photo-alignment material in surface alignment layer 820. Due to the repetitive rotational pattern of liquid crystal molecules in an x-y plane of liquid crystal layer 830, PBP grating 800 may have an in-plane, uniaxial birefringence that varies with position. The liquid crystal structure having the repetitive rotational pattern may give rise to a geometric-phase shift of incident light due to the polarization evolution as the light propagates through liquid crystal layer 830. In some examples, the liquid crystal molecules in liquid crystal layer 830 may be twisted along the z direction to form helical structures. In some examples, liquid crystal molecules in liquid crystal layer 830 may not be twisted.

The diffraction efficiency of PBP grating 800 for surface-normal incident light may be approximately determined by:

$$\eta_0 = cos^2\left(\frac{\pi \Delta n d}{\lambda}\right),$$

and

$$\eta_{\pm 1} = \frac{1 \mp s_3'}{2} sin^2\left(\frac{\pi \Delta n d}{\lambda}\right),$$

where $\eta_m$ is the diffraction efficiency of the mth diffraction order, $\Delta$n is the birefringence of liquid crystal layer 830, *d* is the thickness of liquid crystal layer 830, $\lambda$ is the wavelength of the incident light, and $S_3' = S_3/S_0$ is the normalized Stokes parameter corresponding to the ellipticity of the polarization of the incident light. Thus, if thickness d = $\lambda$/2$\Delta$n (i.e., a half-wave retardation by liquid crystal layer 830), the zeroth order transmission $\eta_0$ may be zero, and all incident light may be diffracted to the $\pm$1 diffraction orders. The zeroth order may be polarization independent, while the $\pm$1

diffraction orders may be sensitive to $S_3'$. For example, when the incident light has a right-handed circular polarization, $S_3' = +1$, and thus $\eta_{+1} = 0$ and $\eta_{-1} = 1$, which indicates that all incident light passing through PBP grating 800 may be diffracted into the -1 diffraction order. When the incident light has a left-handed circular polarization, $S_3' = -1$, $\eta_{+1} = 1$, and $\eta_{-1} = 0$, which indicates that all incident light is diffracted into the +1 diffraction order. Although m = +1 is herein considered the primary order and the m = -1 order is considered the conjugate order, the designation of the orders may be reversed or otherwise changed. In general, only the zeroth and the two first diffracted orders may be possible, regardless of the grating period A and the thickness d.

Moreover, after passing through PBP grating 800, the handedness of the circularly polarized light may be changed to the opposite circular polarization state as the light may experience a relative phase shift about a half wavelength in liquid crystal layer 830. For example, after the right-handed circularly polarized light ($S_3$=1) passes through PBP grating 800, the polarization state of the light (e.g., in the -1 diffraction order) may be changed to the left-handed circular polarization ($S_3$=-1). After the left-handed circularly polarized light (Ss=-1) passes through PBP grating 800, the polarization state of the light (e.g., in the +1 diffraction order) may be changed to the right-handed circular polarization (Ss=1).

The pitch or period A of the repetitive rotational pattern of the liquid crystal molecules in PBP grating 800 may determine, in part, certain optical properties of PBP grating 800. For example, the pitch may determine the diffraction angles of the different diffraction orders according to the grating equation. Generally, the smaller the pitch, the larger the diffraction angle for light of a given wavelength and a given diffraction order.

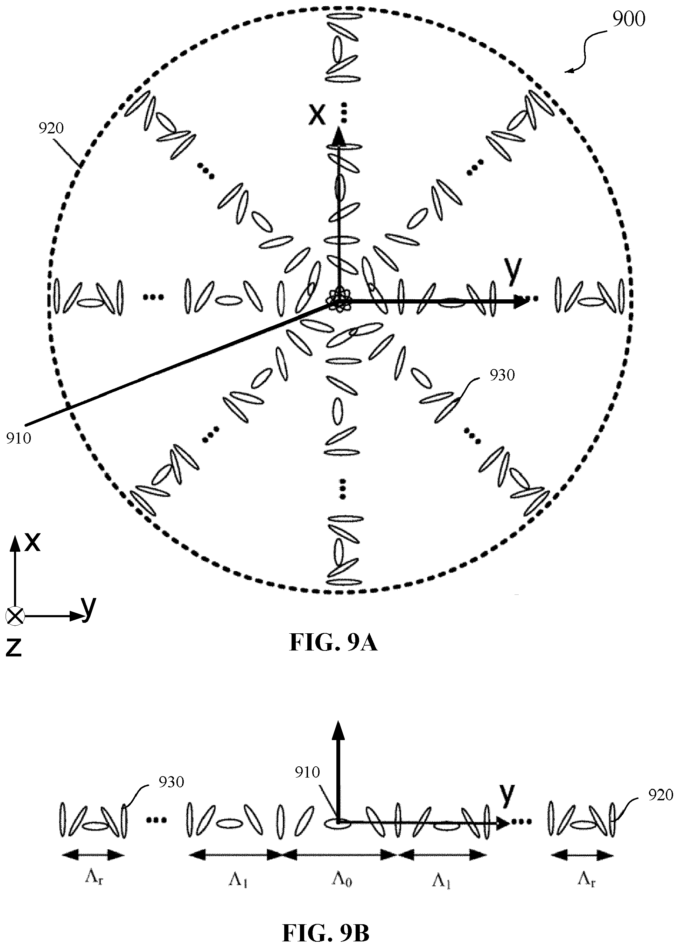

**FIG. 9A** illustrates LC molecule orientations in an example of a PBP lens 900. **FIG. 9B** illustrates the LC molecule orientations of a portion of PBP lens 900. PBP lens 900 may focus or diverge light due to the gradient of geometric phase within the lens, which can be induced by, for example, polarization holography or direct optical writing. As shown in FIG. 9A, PBP lens 900 may have a phase profile of a lens created by LC molecules 930 with different in-plane orientations, where the phase delay $\varphi(r)$ at a location may be a function of the azimuth angle $\psi(r)$ of the optical axis (e.g., orientations of LC molecules 930) at the location: $\varphi(r) = \pm 2\psi(r)$. The azimuth angles $\psi(r)$ of LC molecules 930 may be continuously changed from a center 910 to an edge 920 of the PBP lens 900. The pitch A of the rotational pattern of liquid crystal molecules 930 within which the azimuth angles of LC molecules 930 are rotated by 180° may vary from center 910 to edge 920 of PBP lens 900 to vary the diffraction angle. Accordingly, PBP lens 900 can have a large aperture size and can be made with a thin LC layer that can cause a half-wave retardation.

The portion of PBP lens 900 shown in FIG. 9B may be taken along a radial direction, such as along the y-axis. As shown in FIG. 9B, the pitch A of the rotational pattern of liquid crystal molecules 930 may be a function of distance from center 910 and may progressively decrease as the distance from center 910 increases. For example, the pitch $\Lambda_0$ at center 910 may be the longest, the pitch $\Lambda_r$ at edge 920 may be the shortest, and the pitch $\Lambda_n$ between center 910 and edge 920 may be between pitch $\Lambda_0$ and pitch $\Lambda_r$. Therefore, light incident on the center region of PBP lens 900 may be diffracted by a smaller diffraction angle due to a longer pitch, while light incident on the edge region of PBP lens 900 may be diffracted by a larger diffraction angle due to a shorter pitch. In the x-y plane, to make a PBP lens with a radius r and a focal length $\pm$f (for RHCP and LHCP light), the azimuth angle $\psi(r)$ may be $\psi(r) = \frac{\pi}{2\lambda}(\sqrt{r^2 + f^2} - f)$, where $\lambda$ is the wavelength of the incident light.

More specifically, the Jones vectors of LHCP light and RHCP light can be described as:

$$J_{\pm} = \frac{1}{\sqrt{2}} \begin{bmatrix} 1 \\ \pm j \end{bmatrix},$$

where $J_+$ and $J_-$ represent the Jones vectors of LHCP light and RHCP light, respectively. For PBP lenses, the local azimuthal angle $\psi(r)$ may vary according to:

$$\pm 2\psi(r) = \varphi(r) = -\frac{\omega}{c}(\sqrt{r^2 + f^2} - f)$$

in order to achieve a centrosymmetric parabolic phase distribution, where $\varphi, \omega, c, r,$ and $f$ are the relative phase, angular frequency, speed of light in vacuum, radial coordinate, and focal length of the lens, respectively. After passing through the PBP lens, the Jones vectors may be changed to:

$$J'_{\pm} = R(-\psi)W(\pi)R(\psi)J_{\pm}$$

$$= \begin{bmatrix} cos\psi & -sin\psi \\ sin\psi & cos\psi \end{bmatrix} \begin{bmatrix} e^{-j\frac{\pi}{2}} & 0 \\ 0 & e^{-j\frac{\pi}{2}} \end{bmatrix} \begin{bmatrix} cos\psi & sin\psi \\ -sin\psi & cos\psi \end{bmatrix} \frac{1}{\sqrt{2}} \begin{bmatrix} 1 \\ \pm j \end{bmatrix}$$

$$= \frac{-je^{\pm 2j\psi}}{\sqrt{2}} \begin{bmatrix} 1 \\ \mp j \end{bmatrix} = -je^{\pm 2j\psi}J_{\mp},$$

where $R(\psi)$ and $W(\pi)$ are the rotation and retardation Jones matrix, respectively. As can be seen from the equation above, the handedness of the output light is switched relative to the incident light. In addition, a spatial-varying phase depending on the local azimuthal angle $\psi(r)$ is accumulated. Furthermore, the phase accumulation has opposite signs for RHCP light and LHCP light, and thus the PBP lens may modify the wavefront of RHCP and LHCP incident light differently. For example, a PBP lens may have a positive optical power for RHCP light and a negative optical power for LHCP light, or vice versa.

PBP lens 900 may have a twisted or non-twisted structure along the z-axis. A dual twist or multiple twisted structure along the z-axis may offer achromatic performance in PBP lens 900. A non-twisted structure along the z-axis may be easier to fabricate than a twisted structure, but may be configured for a monochromatic light. In various examples, a PBP liquid crystal lens structure may include one or more PBP liquid crystal lenses having a twisted structure, one or more PBP liquid crystal lenses having a non-twisted structure, or some combinations thereof.

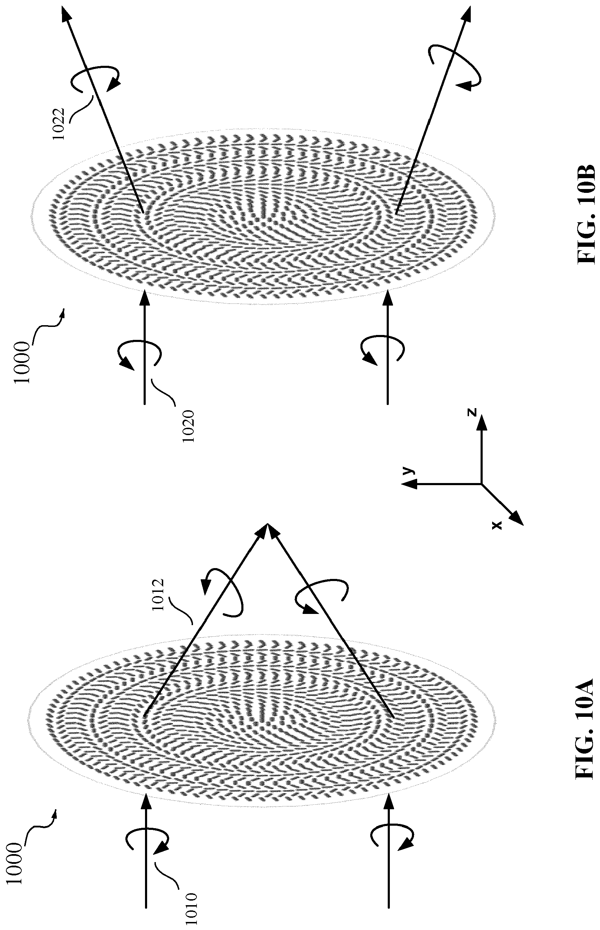

**FIGS. 10A and 10B** illustrate an example of a PBP lens 1000 sensitive to circularly polarized light. PBP lens 1000 may be an example of a polarization diffraction micro-lens in polarization diffraction micro-lens array 745 or PBP lens 900. FIGS. 10A and 10B show the LC molecule orientation of PBP lens 1000 in the x-y plane. The thickness of PBP lens 1000 may be selected to achieve a half-wave retardation d = λ/2Δn as described above. PBP lens 1000 can be a passive or active lens, and can have a positive or negative optical power for RHCP or LHCP light in various examples. In the illustrated example, PBP lens 1000 may have a positive optical power for RHCP light and thus may focus collimated RHCP light 1010 as shown in FIG. 10A. As described above, the handedness of the output light 1012 may be switched relative to the incident collimated RHCP light 1010 and thus may become LHCP light. As shown in FIG. 10B, PBP lens 1000 may have a negative optical power for LHCP light, and thus may diverge collimated RHCP light 1020. The handedness of the output light 1022 may become RHCP.

In some examples, polarization diffraction micro-lenses that are sensitive to linearly polarized light may be used to extract and collimate light emitted by micro-LEDs (*e.g.*, micro-OLEDs). In some examples, other flat liquid crystal lenses may be used to extract and collimate light emitted by micro-LEDs, where the no-zero optical power of the lens may be provided by the refractive index gradient caused by the variation of the rotational angle of the liquid crystal molecules at different areas of the lens. The liquid crystal lens may include, for example, nematic liquid crystal lens, polymer-stabilized nematic liquid crystal lens, polymer-stabilized blue phase liquid crystal lens, polymer-dispersed nematic liquid crystal lens, and the like. Nematic liquid crystals may include rod-like molecules, which exhibit optical and dielectric anisotropies due to their anisotropic molecular structures. When properly aligned in an LC cell, the long axes of the nematic liquid crystal molecules may be approximately parallel to each other, where the alignment direction is referred to as the LC director. Light polarized along the LC director (the extraordinary ray) may experience extraordinary refractive index $n_e$, while light polarized perpendicular to the LC director (the ordinary ray) may experience ordinary refractive index $n_o$. If the light is polarized at an angle θ with respect to the LC director, it may see an effective refractive index $n_{eff}(\theta)$. The alignment direction of the LC molecules may be pre-tilted such that the rotational angle θ smoothly changes from about 0° (i.e., planar alignment) around the center to about 90° (i.e., perpendicular or homeotropic alignment) on the edge of the liquid crystal lens. Thus, the optical path difference (OPD) between the edge area and other areas of the LC lens can be expressed as:

$$OPD = d(n_e \text{-} n_{eff}(\theta)).$$

Therefore, the LC lens can exhibit a refractive index gradient to create a lens-like phase profile, and may be equivalent to a lens having an isotropic medium with different thicknesses at different areas of the lens. The focal length of the LC lens may be given by:

$$f = \frac{\pi D^2}{4\lambda\Delta\delta},$$

where D is the aperture size (e.g., the diameter) of the LC lens, $\lambda$ is the wavelength, $\Delta\delta$ is the phase difference between the edge and center areas of the aperture and can be expressed as:

$$\Delta\delta = \frac{2\pi}{\lambda} d\Delta n ,$$

where $\Delta n$ is the difference in refractive index between the center and edge areas of the aperture. Thus, the focal length of the LC lens can be rewritten as:

$$f = \frac{r^2}{2d\Delta n} ,$$

where r is the radius of the aperture of the LC lens. When the refractive index in the center area is less than that of the edge area, $\Delta n$ is negative and thus f is negative.

The refractive index gradient and the gradient of the rotational angles of the LC directors can be introduced by, for example, an inhomogeneous electric field, inhomogeneous LC morphology, photo-alignment, micro-rubbing, non-uniform surface polymerization combined with rubbing, creation of surface polymer network, gradient of easy axis or anchoring energy, and the like. In some implementations, the liquid crystal lens may include a diffractive optical element (e.g., a Fresnel lens), and the zones of the diffractive optical element (e.g., the Fresnel zones) may be formed by patterned LC alignment or by phase separation patterning of LC layer doped with pre-polymers. The alignment pattern may be created by, for example, photo-alignment.

As described above, the overall efficiency of a near-eye display system may be the product of the efficiency of individual components in the display system and may also depend on how the components are coupled together. For example, the overall efficiency $\eta_{tot}$ of the near-eye display of FIG. 5 may depend on the light emitting efficiency of image source 520, and the light coupling efficiency from image source 520 to user's eye 590 by display optics 510. When the emission angles of light emitters in an array of light emitters are uniformly controlled (e.g., collimated to have small emission cones), light emitted by the light emitters may not be uniformly collected and delivered to the eyebox of the display system. For example, light emitted by light emitters near edges of the array of light emitters may be collected and delivered to the eyebox of the display system at lower efficiencies than light emitted by light emitters at the center of the array of light emitters, which may cause non-uniform intensity or brightness variation in the displayed images. Therefore, light emitted from light emitters at the edges of the array of light emitters may need to be deflected differently than light emitted from light emitters at the center of the array of light emitters.

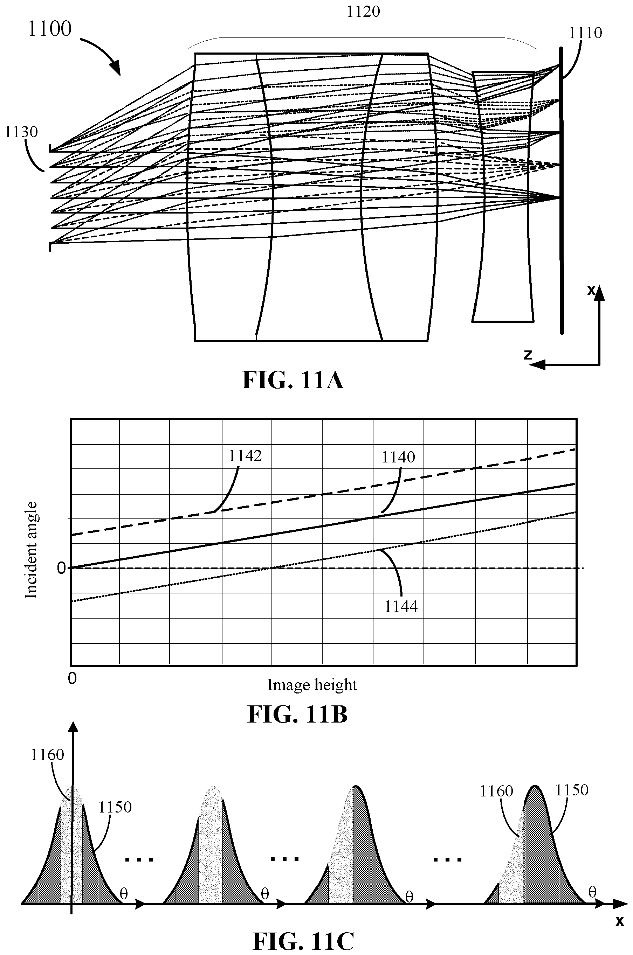

FIG. 11A illustrates an example of a micro-LED-based display system 1100 including a micro-LED array 1110 (e.g., including a one dimensional or two-dimensional array of micro-OLEDs) and display optics 1120. FIG. 11B illustrates angles of light incident on display optics 1120 from micro-LED array 1110. As illustrated in the example, due to the limited field of view (or acceptance angle) and/or the size of exit pupil 1130 (or eyebox) of display system 1100, different angular portions of light from the respective micro-LEDs in micro-LED array 1110 may pass through an exit pupil 1130 of display system 1100. For example, as shown by a line 1140 in FIG. 11B, the chief ray of the light beam from a micro-LED at the center of micro-LED array 1110 that may reach the user's eyes may be incident on display optics 1120 at about 0°, while the chief ray of the light beam from a micro-LED at an edge of micro-LED array 1110 that may reach the user's eyes may be incident on display optics 1120 at, for example, about 20°, which may be referred to as chief ray walk-off. Lines 1142 and 1144 show the angular range of the light from each micro-LED at a respective height in micro-LED array 1110 that can reach the user's eyes. When the light intensity of the light beam from each micro-LED is not uniform in all directions (such as having a narrow beam profile), light from different micro-LEDs may be projected to the user's eyes at different efficiencies due to the different angular portions of light from the respective micro-LEDs in micro-LED array 1110 that pass through exit pupil 1130.

FIG. 11C illustrates an example of the portions of light beams emitted by micro-LED array 1110 that may be collected and projected by display optics 1120 to user's eyes. As described above, after the collimation by the micro-lenses, the beam profile 1150 of the light beam emitted from each micro-LED in micro-LED array 1110 may have a small HWHM angle (e.g., about 20° or about 15°). Due to the limited acceptance angles and/or the limited size of the exit pupil of display system 1100, only a portion of each light beam may reach a user's eye through display optics 1120. In addition, due to the chief ray walk-off described above, the portion of each light beam that can reach the user's eyes may be within a different respective angular range for each respective micro-LED as shown in FIGS. 11A and 11C. The total power of each light beam may be indicated by the total area under beam profile 1150 that represents the beam brightness profile of the light beam, while the total power of each light beam that may reach the user's eye may be indicated by the total area of a bright region 1160 under beam profile 1150, which may only be a portion of the total area under beam profile 1150. For micro-LEDs at the center of micro-LED array 1110, the area of bright region 1160 may be a large portion of the total area below beam profile 1150 because of the narrow beam profile of the light beam, and thus the coupling efficiencies may be high for micro-LEDs at the center of micro-LED array 1110. However, for micro-LEDs at the edge of micro-LED array 1110, the area of bright region 1160 may only be a small portion of the total area below beam profile 1150 as shown in FIG. 11C. In other words, the area of bright region 1160, and thus the coupling efficiency of the micro-LEDs in micro-LED array 1110, may decrease significantly from the center to the edges of micro-LED array 1110. Therefore, to improve the uniformity of the intensity or brightness of the displayed images, light emitted from micro-LEDs at the edges of micro-LED array 1110 may need to be deflected differently than light emitted from micro-LEDs at the center of micro-LED array 1110.

One technique of deflect light emitted by different micro-LEDs differently is using a micro-lens array that includes decentered micro-lenses for at least some micro-LEDs. For example, the micro-lens array may have a pitch different from the pitch of the array of micro-LEDs or may otherwise be center-offset with respect to the array of micro-LEDs, such that the light beam emitted by each micro-LED in the array may not only be collimated or focused, but may also be deflect by a respective angle towards the display optics.

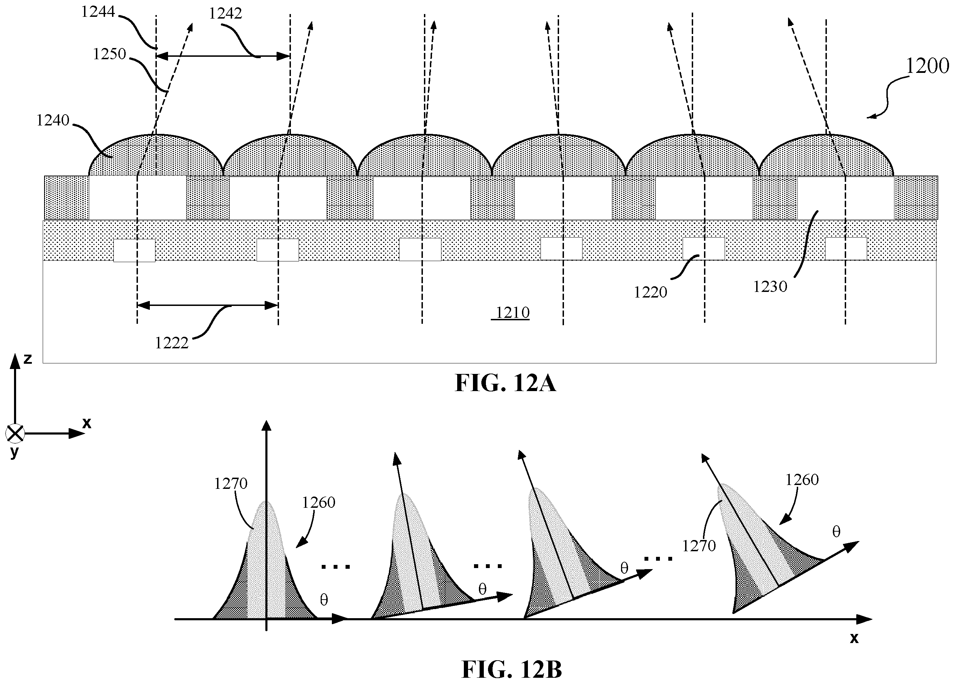

**FIG. 12A** illustrates an example of a micro-OLED device 1200 including a micro-OLED array and a micro-lens array 1240 for extracting and converging light from the micro-OLED array. As described above, the micro-OLED array may include a driving layer 1210, an OLED layer 1220, and a color filter layer 1230. Even though not shown in FIG. 12A, micro-OLED device 1200 may also include a cover glass and spacers that separate micro-lens array 1240 from the cover glass, as described above with respect to FIG. 7A. Driving layer 1210 may include, for example, a CMOS backplane including pixel drive circuits fabricated thereon, and/or thin-film transistor (TFT) circuits on a glass substrate. OLED layer 1220 may include an array of white-light emitting micro-OLEDs controlled by the pixel drive circuits in driving layer 1210. Each micro-OLED in OLED layer 1220 may include, for example, a bottom electrode (e.g., a cathode including a metal layer, such as Al or Ag), an electron transport layer, an organic light emitting layer, a hole transport layer, and a top electrode (e.g., an anode including an ITO layer). Color filter layer 1230 may include array of color filters that include red, green, and blue color filters arranged according to a certain pattern, and may convert the white light emitted by the micro-OLEDs into red, green, and blue light. In some examples, OLED layer 1220 may include an array of micro-OLEDs that can directly emit red, green, and blue light, and thus color filter layer 1230 may not be used.

Micro-lens array 1240 may be formed directly on the micro-OLED array or may be formed on a substrate and then bonded to the micro-OLED array. For example, micro-lens array 1240 may be etched in a dielectric layer (e.g., an oxide layer such as a $SiO_2$ layer), or may be formed on a dielectric layer (e.g., an oxide layer or a polymer layer) deposited on the micro-OLED array. The focal length and the distance of the micro-lenses from the corresponding micro-OLEDs may be configured such that the light beam after passing through each micro-lens may be a collimated beam, a converging beam, or a diverging beam.

A pitch 1222 of the micro-OLED array may be different from (*e.g.*, less than or greater than) a pitch 1242 of micro-lens array 1240, and thus the optical axis 1244 of each micro-lens in micro-lens array 1240 may be offset from the center of a respective micro-OLED in the micro-OLED array by a different distance. As such, the chief ray 1250 of the light beam from each micro-OLED after passing through the corresponding micro-lens may have a different respective angle. In the example shown in FIG. 12A, pitch 1222 of the micro-OLED array may be greater than pitch 1242 of micro-lens array 1240, and thus the optical axis of each micro-lens in micro-lens array 1240 may be offset from the center of the respective micro-OLED in the micro-OLED array by a different distance. The offset may be a function of the location of the micro-lens. For example, the offset may linearly increase as the distance of the micro-lens from the center of micro-OLED device 1200 increases. As a result, the chief rays 1250 of the light beams extracted from the micro-LEDs after passing through the corresponding micro-lenses may be in different propagation directions and may converge as shown in the example.

In various examples, the pitch of micro-lens array 1240 may be uniform or non-uniform. For example, the pitch of a two-dimensional micro-lens array may be uniform in two orthogonal directions, uniform in one direction only, or non-uniform in both directions. The pitch may also be the same or different in the two orthogonal directions. The pitch of micro-lens array 1240 may be different from the pitch of the micro-OLED array in one or two dimensions.

**FIG. 12B** illustrates an example of the portions of the light beams emitted by the micro-OLED array of micro-OLED device 1200 that may be collected by the display optics (e.g., display optics 1120). As illustrated, after the collimation by the micro-lenses, the beam profile 1260 of the light beam emitted from each micro-OLED in the micro-OLED array may have a small HWHM angle (e.g., about 20°, about 15°, or smaller). The total power of each light beam may be indicated by the total area under beam profile 1260 that represents the beam brightness profile of the light beam. Due to the chief ray angle tuning described above with respect to FIG. 12A, the portion of each light beam that can reach the user's eyes may be within a similar angular range where the portion of the light beam may have the highest intensity or brightness for each respective micro-OLED as shown by bright regions 1270 in FIG. 12B. Thus, the total power of each light beam that may reach the user's eye as indicated by the total area of bright region 1270 under beam profile 1260 may be substantially the same and may be high. Therefore, the coupling efficiency of the light emitted by the micro-OLEDs in the micro-OLED array may be about the same from the center to the edges of the micro-OLED array. As such, both the coupling efficiencies and the uniformity of the coupling efficiencies may be improved for the micro-OLEDs in the micro-OLED array.

Redirecting the emitted light using off-centered micro-lenses described above may require a precise pixel-level alignment (and thus may be difficult to manufacture), and may have limited deflection angle due to certain geometry limitations. For example, to deflect an emitted light beam by a large angle, the center of the micro-lens in the micro-lens array may need to be offset from the center of the corresponding light emitting device in the array of light emitting devices by a large amount, which may cause crosstalk and/or opposite deflecting due to the small sizes and pitches of the array of light emitting devices and the micro-lens array.

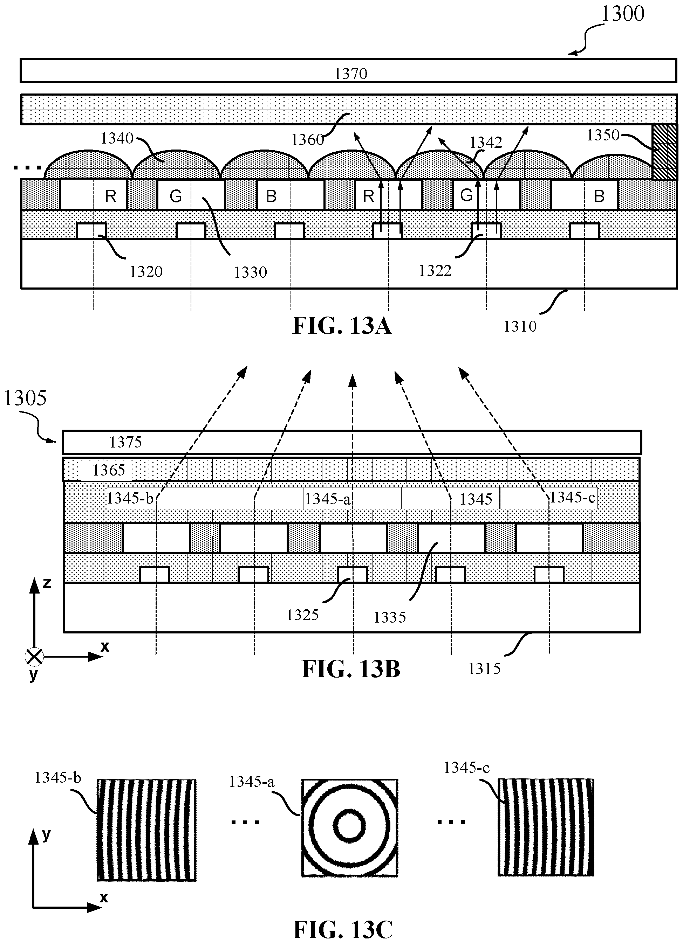

FIG. 13A illustrates an example of a micro-OLED device 1300. In the illustrated example, micro-OLED device 1300 may include a driving layer 1310, an OLED layer 1320, a color filter layer 1330, a micro-lens array 1340, a cover glass 1360, spacers 1350 that separate micro-lens array 1340 from cover glass 1360, and a polarizer 1370, a s described above with respect to, for example, FIG. 7A. Driving layer 1310 may include, for example, a CMOS backplane including pixel drive circuits fabricated thereon, and/or thin-film transistor (TFT) circuits on a glass substrate. OLED layer 1320 may include an array of white-light emitting micro-OLEDs controlled by the pixel drive circuits on driving layer 1310. Each micro-OLED in OLED layer 1320 may include, for example, a bottom electrode, an electron transport layer, an organic light emitting layer, a hole transport layer, and a top electrode. Color filter layer 1330 may include an array of color filters that include red, green, and blue color filters arranged according to a certain pattern, and may convert the white light emitted by the micro-OLEDs in OLED layer 1320 into red, green, and blue light.

Spacers 1350 may be used to form an air gap between micro-lens array 1340 and cover glass 1360, such that micro-lens array 1340 may include convex lenses to collimate light from the micro-OLEDs and/or color filters. Cover glass 1360 may include a transparent substrate (e.g., including glass or quartz) that may protect micro-lens array 1340, color filter layer 1330, and/or OLED layer 1320. Polarizer 1370 may include a circular polarizer that may block, for example, ambient light reflected from the bottom electrodes of the micro-LEDs and/or the interface between air and micro-lens array 1340. As described above with respect to FIG. 7A, polarizer 1370 may include a first quarter waveplate (QWP), a linear polarizer, and an optional second QWP. For example, polarizer 1370 may allow right-handed circularly polarized light to pass through. The right-handed circularly polarized light may be reflected by a reflective surface (e.g., the bottom electrode) into left-handed circularly polarized light, and may be blocked by polarizer 1370.

Micro-lens array 1340 may include an array of convex lenses fabricated in a transparent material layer and may be bonded to color filter layer 1330. A pitch of the micro-OLED array may be different from (e.g., less than or greater than) a pitch of micro-lens array 1340, and thus the optical axis of each micro-lens in micro-lens array 1340 may be offset from the center of a respective micro-OLED in the micro-OLED array by a different distance. As such, the chief ray of the light beam from each micro-OLED after passing through the corresponding micro-lens may be different. In the example shown in FIG. 13A, the pitch of the micro-OLED array may be greater than the pitch of micro-lens array 1340, and thus the optical axis of each micro-lens in micro-lens array 1340 may be offset from the center of a respective micro-OLED in the micro-LED array by a different distance. In order to redirect the chief ray by a large angle, the offset between the optical axis of a micro-lens and the center of a respective micro-OLED may need to be large. As such, some micro-lenses (e.g., micro-lens 1342) may be partially overlap with two adjacent micro-OLEDs and may deflect the light beams emitted by the two adjacent micro-OLEDs to substantially opposite directions. Some micro-OLEDs (e.g., micro-OLED 1322) may at least partially overlap with two adjacent micro-lenses and thus the light beam emitted by micro-OLED 1322 may be deflected by the two adjacent micro-lenses to substantially opposite directions. Therefore, there may be crosstalk between the light beams emitted by different micro-OLEDs and/or opposite deflecting of a light beam from a micro-OLED by two micro-lenses.

According to certain examples, the polarization diffraction micro-lens array disclosed herein can have different phase profiles, such as the phase profile of an on-axis spherical lens, the phase profile of an on-axis freeform lens, the phase profile of an off-axis freeform lens, or a combination, to shape the emission cones of the light beams emitted by different light emitting sources differently, thereby maximizing the light extraction efficiency and overall system efficiency, without physically displacing the polarization diffraction micro-lens array with respect to the array of micro-OLEDs. For example, the polarization diffraction micro-lens array can be center-aligned with the array of light emitting device, rather than being offset from centers of the light emitting devices, while deflecting the light beams emitted by the light emitting devices to different desired directions. Therefore, the crosstalk and/or opposite deflecting associated with plano-convex micro-lenses as described above with respect to FIG. 13A can be avoided.

FIG. 13B illustrates an example of a micro-OLED device 1305 including polarization diffraction micro-lenses for light extraction and beam shaping. In the illustrated example, micro-OLED device 1305 may include a driving layer 1315, an OLED layer 1325, a color filter layer 1335, an array (e.g., a two-dimensional array) of polarization diffraction micro-lenses 1345, a cover glass 1365, and a polarizer 1375. Driving layer 1315, OLED layer 1325, color filter layer 1335, cover glass 1365, and polarizer 1375 may be similar to driving layer 1310, OLED layer 1320, color filter layer 1330, cover glass 1360, and polarizer 1370, respectively. The array of polarization diffraction micro-lenses 1345 may be bonded to OLED layer 1325 or color filter layer 1335 using, for example, an optically clear adhesive.

Each polarization diffraction micro-lens 1345 may include a flat lens, such as a PBP micro-lens made of birefringent materials such as liquid crystal polymers, as described above. Polarization diffraction micro-lenses 1345 in the array of polarization diffraction micro-lenses 1345 may have the same focal length. The center of each polarization diffraction micro-lens 1345 may be aligned with the center of a corresponding micro-OLED in OLED layer 1325. Some polarization diffraction micro-lenses 1345 may have a phase profile of an on-axis spherical or freeform lens, where the center of a polarization diffraction micro-lens may be on the optical axis of the polarization diffraction micro-lens, such that the chief ray of the emitted light beam may be parallel to the optical axis (e.g., in the z direction). Some polarization diffraction micro-lenses 1345 may have a phase profile of an off-axis spherical or freeform lens, where the center of a polarization diffraction micro-lens may not be on the optical axis of the polarization diffraction micro-lens, such that the chief ray of the emitted light beam may be titled with respect to the optical axis (e.g., the z direction).

In some examples, the array of micro-OLEDs may include an array of pixels, where each pixel of the array of pixels may include a micro-LED configured to emit red light or including a color filter that allows red light to pass through, a micro-LED configured to emit green light or including a color filter that allows green light to pass through, and a micro-LED configured to emit blue light or including a color filter that allows blue light to pass through. The phase profiles of the three polarization diffraction micro-lenses for the three micro-LEDs in the pixel may be configured differently to compensate for the dispersion effect of diffraction optical devices, such that the three polarization diffraction micro-lenses may deflect chief rays of the light beams emitted by the three micro-LEDs in a same pixel by substantially same deflection angles, and thus different color components of the pixel may converge on a same area of the user's retina to form a clear image.

**FIG. 13C** illustrates an example of the array of polarization diffraction micro-lenses 1345. Polarization diffraction micro-lenses 1345 in the array of polarization diffraction micro-lenses 1345 may have the same focal length, but may have different respective offsets between the center and the optical axis of each polarization diffraction micro-lens 1345. In the example shown in FIG. 13C, polarization diffraction micro-lens 1345-a in the center of the array of polarization diffraction micro-lenses 1345 may have a phase profile of an on-axis lens and may be radially symmetrical, and thus the chief ray of the output light beam may be parallel to the optical axis (e.g., in the z direction). Polarization diffraction micro-lens 1345-b in the left portion of the array of polarization diffraction micro-lenses 1345 may have a phase profile of an off-axis lens, where the optical axis of polarization diffraction micro-lens 1345-b may be to the right of the center of polarization diffraction micro-lens 1345-b, and thus the chief ray of the incident light beam may be deflected rightward by polarization diffraction micro-lens 1345-b as shown in FIG. 13B. Polarization diffraction micro-lens 1345-c in the right portion of the array of polarization diffraction micro-lenses 1345 may also have a phase profile of an off-axis lens, where the optical axis of polarization diffraction micro-lens 1345-c may be to the left of the center of polarization diffraction micro-lens 1345-c, and thus the chief ray of the incident light beam may be deflected leftward by polarization diffraction micro-lens 1345-c as shown in FIG. 13B. Thus, the example of the array of polarization diffraction micro-lenses 1345 shown in FIG. 13C may cause the chief rays of the light beams from the micro-OLEDs to converge as shown in FIG. 13B, and may be used in, for example, a display system where the size of the micro-OLED array is greater than the aperture of the display optics.

In another example, polarization diffraction micro-lens 1345-b may be in the right portion of the array of polarization diffraction micro-lenses 1345, and the chief ray of an incident light beam may be deflected rightward by polarization diffraction micro-lens 1345-b since the optical axis of polarization diffraction micro-lens 1345-b may be to the right of the center of polarization diffraction micro-lens 1345-b. Polarization diffraction micro-lens 1345-c may be in the left portion of the array of polarization diffraction micro-lenses 1345, and the chief ray of an incident light beam may be deflected leftward by polarization diffraction micro-lens 1345-c since the optical axis of polarization diffraction micro-lens 1345-c may be to the left of the center of polarization diffraction micro-lens 1345-c. Thus, the array of polarization diffraction micro-lenses 1345 may cause the chief rays of the light beams from the micro-OLEDs to diverge, and may be used in, for example, a display system where the aperture of the display optics is larger than the micro-OLED array.

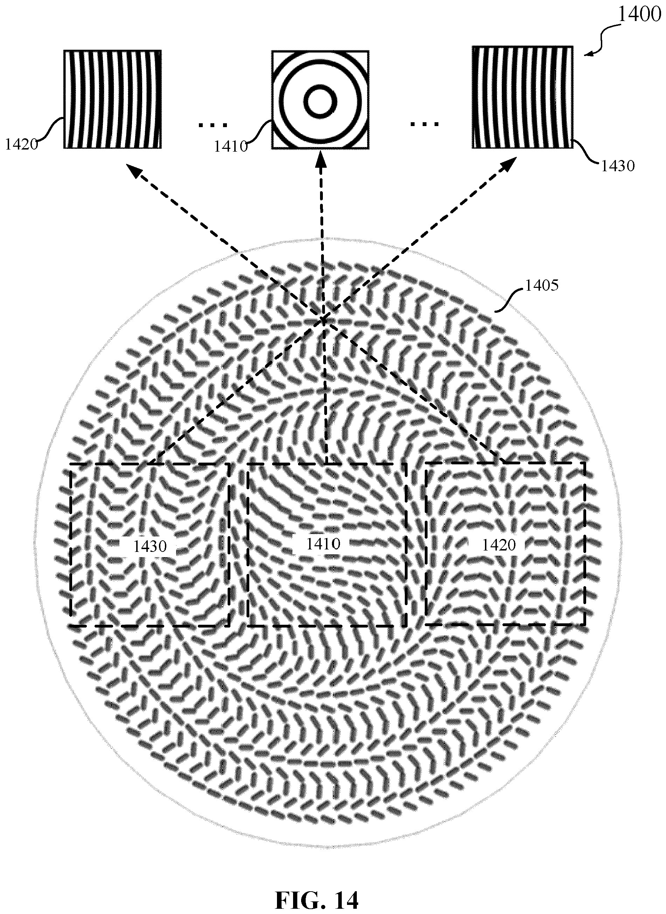

**FIG. 14** illustrates an example of an array of polarization diffraction micro-lenses 1400. The polarization diffraction micro-lenses in the array of polarization diffraction micro-lenses 1400 may have the same focal length, but may have different respective offsets between the center and the optical axis of each polarization diffraction micro-lens. In one example, the polarization diffraction micro-lenses in the array of polarization diffraction micro-lenses 1400 may be different portions of a polarization diffraction lens 1405 that has a larger aperture and the same focal length as each polarization diffraction micro-lens of the array of polarization diffraction micro-lenses 1400. For example, polarization diffraction micro-lens 1410 may be a center portion of polarization diffraction lens 1405, and may have a phase profile of an on-axis lens. Polarization diffraction micro-lens 1420 may have a phase profile of an off-axis lens and may be a right portion of polarization diffraction lens 1405, where the optical axis of polarization diffraction micro-lens 1420 may be to the left of the center of polarization diffraction micro-lens 1420 such that polarization diffraction micro-lens 1420 may deflect the chief ray of an incident light beam leftward. Polarization diffraction micro-lens 1430 may have a phase profile of an off-axis lens and may be a left portion of polarization diffraction lens 1405, where the optical axis of polarization diffraction micro-lens 1430 may be to the right of the center of polarization diffraction micro-lens 1430 such that polarization diffraction micro-lens 1420 may deflect the chief ray of an incident light beam rightward.

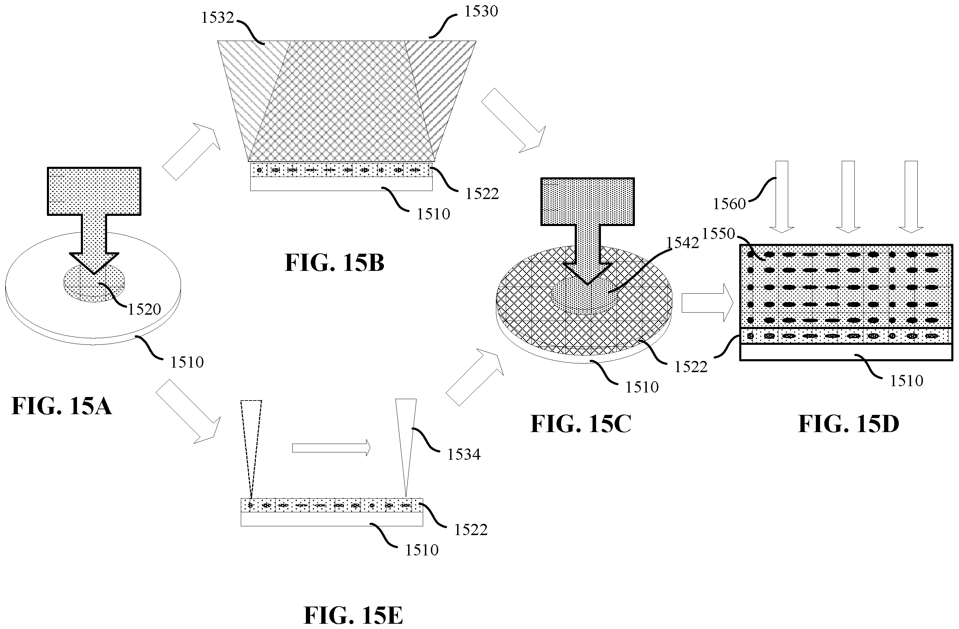

**FIGS. 15A-15D** illustrate an example of a process of fabricating polarization diffraction micro-lenses disclosed herein. In the example shown in **FIG. 15A,** a photoalignment material 1520 (e.g., including a photocurable monomer material) may be coated on the surface of a substrate 1510 using, for example, spin coating or spray coating, to form a photoalignment material layer. In one example, the photoalignment material may include brilliant yellow (BY) dissolved in dimethylformamide (DMF). After the coating, the photoalignment material layer may be dried by, for example, baking at an elevated temperature (e.g., greater than about 100 °C) to remove the solvent. The photoalignment material layer may have a thickness, for example, about 10 nm to about 50 nm.

**FIG. 15B** shows that the photoalignment material layer may be exposed to an interference pattern generated by two overlapping circularly polarized light beams 1530 and 1532 to form an alignment layer 1522 on substrate 1510. For example, circularly polarized light beams 1530 and 1532 may include a left-handed circularly polarized beam and a right-handed circularly polarized beam, and may be incident on a same area of the photoalignment material layer at desired incident angles to generate a desired polarization interference pattern and record the polarization interference pattern in the photoalignment material layer. The incident angles of the two circularly polarized beams may be selected to achieve the desired periodicity and pattern in the alignment layer. The exposure of the photoalignment material layer to the interference pattern may cause the polymerization of the photocurable monomers of the photoalignment material at the bright regions of the interference pattern to form polymerized chains. Thus, the orientation of the alignment pattern in alignment layer 1522 may vary across the alignment layer according to the interference pattern.

**FIG. 15C** shows that a layer of a birefringent material 1542 may be deposited on alignment layer 1522, for example, by spin coating or spray coating. Birefringent material 1542 may include optically anisotropic molecules (e.g., liquid crystal molecules) and a curable stabilizing material (e.g., photocurable monomers or polymers). For example, birefringent material 1542 may include liquid crystal molecules mixed with photocurable monomers or polymers to form polymerizable liquid crystal reactive mesogens (RMs). The birefringent material may have a birefringence greater than about 0.1, greater than about 0.15, greater than about 0.2, or larger. In some examples, the birefringent material may also include a photoinitiator, a chiral dopant, and/or a dichroic dye. The optically anisotropic molecules in the layer of the birefringent material deposited on the alignment layer may align with the alignment pattern in the alignment layer. In some examples, the optically anisotropic molecules in the layer of the birefringent material may form helical structures.

**FIG. 15D** shows that the layer of the birefringent material may be cured to fix the curable stabilizing material, which may stabilize the liquid crystal molecules in the layer of the birefringent material. In one example, the curing may be performed by exposing the layer of the birefringent material using a uniform ultraviolet (UV) light beam 1560 to polymerize the photocurable monomers or cross-link the polymers to form crosslinked polymers. The layer of the birefringent material with the optically anisotropic molecules stabilized or fixed by the crosslinked polymers may from a polarization diffraction lens. In some examples, multiple liquid crystal reactive mesogen layers 1550 may be coated on alignment layer 1522 layer by layer, until a desired thickness and/or twist angle (e.g., to achieve a half-wave retardation for high diffraction efficiency) is reached, and then the multiple liquid crystal reactive mesogen layers 1550 may be cured using uniform UV light beam 1560. In some examples, operations shown in FIGS. 15C and 15D may be performed in multiple cycles, where a liquid crystal reactive mesogen layer may be coated and cured in each cycle, until the desired thickness and/or twist angle is achieved.

**FIG. 15E** illustrates an example of a process for patterning alignment layer 1522 using direct laser writing techniques, such as single photon laser fabrication techniques or two-photon polymerization (TPP) techniques. In the illustrated example, a laser beam 1534 including ultrafast laser pulses (e.g., about 100 fs) may be focused using a high numerical aperture objective lens into the photoalignment material layer to polymerize the photocurable monomers or cross-link the polymers to form crosslinked polymers at the focal spot of the laser beam. In some examples, laser beam 1534 may be polarized. Laser beam 1534 may be scanned across the photoalignment material layer according to the desired pattern of the alignment layer.

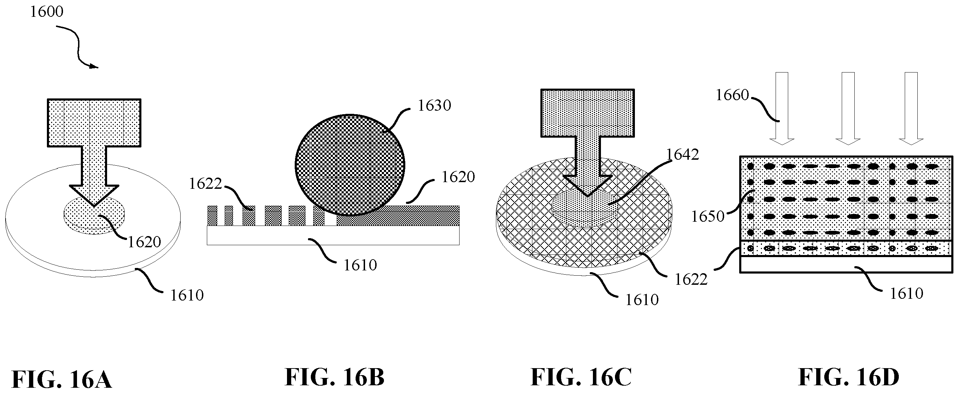

**FIGS. 16A-16D** illustrate an example of a process 1600 of fabricating polarization diffraction micro-lenses disclosed herein. In the example shown in **FIG. 16A**, a negative photoresist or another UV or thermally curable polymer material, such as photocurable polyurethane, thermally curable epoxy, and photocurable acrylate/methacrylate, may be coated on the surface of a substrate 1610 using, for example, spin coating or spray coating, to form a photoresist layer 1620. The photoresist layer may have a thickness, for example, about 10 nm to about 50 nm. In one example, the negative photoresist may include SU-8 2000 (MicroChem). In some examples, photoresist layer 1620 may be baked before imprinting.

**FIG. 16B** shows that an nanoimprint lithography (NIL) process may be performed to form alignment patterns in photoresist layer 1620. NIL techniques may improve the yield and reduce the cost due to the relatively simple and quick processes. In sone example, a master mold with patterns same as or similar to the desired patterns in the alignment layer may be made by, for example, two-photon polymerization-based direct-laser writing technique. A soft stamp, such as a transparent polymer dimethylsiloxane (PDMS) stamp, may be cast from the master mold. The soft stamp may have patterns complementary to the desired patterns in the alignment layer. The soft stamp may be positioned on and pressed against photoresist layer 1620, for example, using a roller 1630, such that photoresist layer 1620 may have the desired patterns formed therein. Photoresist layer 1620 may then be cured by UV light, for example, through the transparent PDMS stamp, to initiate cross-linking polymerization reactions. In some examples, heat may be applied to photoresist layer 1620 to facilitate the polymerization. After the curing, the soft stamp may be gradually delaminated from photoresist layer 1620, and the remaining photoresist layer 1620 including patterns formed therein may be used as an alignment layer 1622. In some examples, after the delamination of the softa stamp, photoresist layer 1620 may be UV cured again and/or may be baked.

**FIG. 16C** shows that a layer of a birefringent material 1642 may be deposited on alignment layer 1622, for example, by spin coating or spray coating, as described above with respect to, for example, FIG. 15C. The birefringent material may include, for example, liquid crystal molecules mixed with photocurable monomers or polymers to form polymerizable liquid crystal reactive mesogens. In some examples, the birefringent material may also include a photoinitiator, a chiral dopant, and/or a dichroic dye. The optically anisotropic liquid crystal molecules in the layer of the birefringent material deposited on the alignment layer may align with patterns in alignment layer 1622. In some examples, the optically anisotropic liquid crystal molecules in the layer of the birefringent material may form helical structures.

**FIG. 16D** shows that the layer of the birefringent material may be cured to fix the curable stabilizing material, which may stabilize the liquid crystal molecules in the layer of the birefringent material. In one example, the curing may be performed by exposing the layer of the birefringent material using a uniform UV light beam 1660 to polymerize the photocurable monomers or cross-link the polymers to form crosslinked polymers. The layer of the birefringent material with the optically anisotropic liquid crystal molecules stabilized or fixed by the crosslinked polymers may from a polarization diffraction lens. In some examples, multiple liquid crystal reactive mesogen layers 1650 may be coated on alignment layer 1622 layer by layer, until a desired thickness and/or twist angle (e.g., to achieve a half-wave retardation for high diffraction efficiency) is achieved, and then the multiple liquid crystal reactive mesogen layers 1650 may be cured using uniform UV light beam 1660. In some examples, operations shown in FIGS. 16C and 16D may be performed in multiple cycles, where a liquid crystal reactive mesogen layer may be coated and cured in each cycle, until the desired thickness and/or twist angle is achieved.

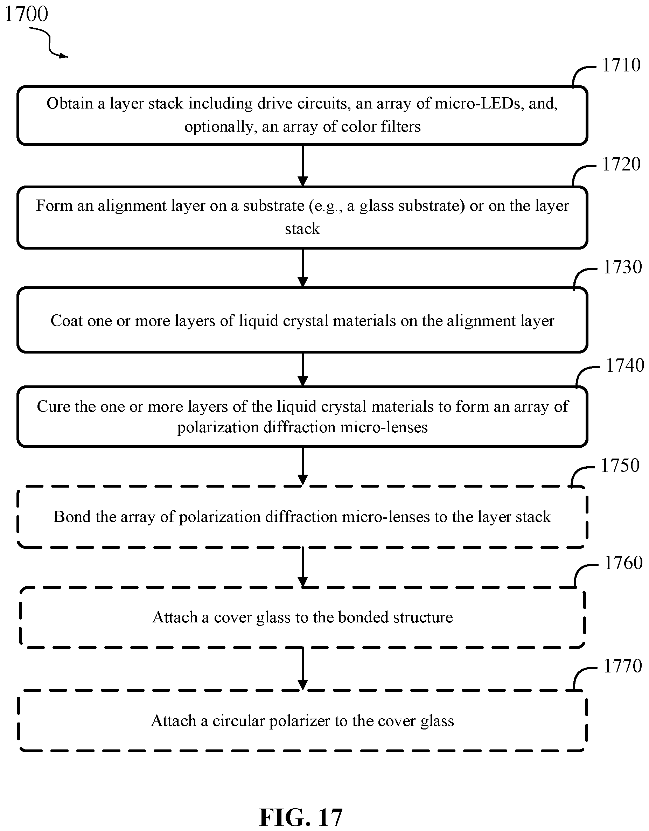

**FIG. 17** includes a flowchart 1700 illustrating an example of a process of fabricating a micro-LED device. It is noted that the operations illustrated in FIG. 17 provide particular processes for fabricating micro-LED devices. Other sequences of operations can also be performed according to alternative examples. For example, alternative examples may perform the operation in a different order. Moreover, the individual operations illustrated in FIG. 17 can include multiple sub-operations that can be performed in various sequences as appropriate for the individual operation. Furthermore, some operations can be added or removed depending on the particular applications. In some implementations, two or more operations may be performed in parallel. One of ordinary skill in the art would recognize many variations, modifications, and alternatives.

Operations in block 1710 of flowchart 1700 may include obtaining a layer stack that includes drive circuits, an array (e.g., a two-dimensional array) of micro-LEDs, and, optionally, an array of color filters. The drive circuits may be formed on a CMOS backplane and/or a TFT layer and may include pixel drive circuits for driving individual micro-LEDs. The array of micro-LEDs may include, for example, micro-OLEDs or III-V semiconductor micro-LEDs. In some examples, the pitch of the array of micro-LEDs may be less than about 20 $\mu$m, less than about 10 $\mu$m, or less than about 5 $\mu$m. In some examples, the array of micro-LEDs may include an array (e.g., a two-dimensional array) of white-light emitting micro-OLEDs and an array (e.g., a two-dimensional array) of color filters that include red, green, and blue color filters. In some examples, the array of micro-LEDs may include a two-dimensional array of micro-OLEDs that can intrinsically emit red, green, and blue light. Each micro-OLED may include, for example, a bottom electrode (e.g., a cathode including a metal layer, such as Al or Ag), an electron transport layer, an organic light emitting layer, a hole transport layer, and a top electrode (e.g., an anode including an ITO layer). In some examples, the array of micro-LEDs may include a two-dimensional array of III-V semiconductor micro-LEDs that can emit red, green, and blue light directly. The array of micro-LEDs may form a two-dimensional array of pixels, where each pixel may include a first micro-LED configured to emit light in a first wavelength range (e.g., red light), a second micro-LED configured to emit light in a second wavelength range (e.g., green light), and a third micro-LED configured to emit light in a third wavelength range (e.g., blue light).

Operations at block 1720 may include forming an alignment layer on a substrate (e.g., a glass substrate) or on the layer stack. In some examples, the substrate may be used as the cover glass. As described above with respect to, for example, FIGS. 15A, 15B, 15E, 16A, and 16B, the alignment layer may be formed on the substrate by, for example, polarization interference patterning, direct laser writing patterning, or imprint lithography. For example, a photoalignment material layer including brilliant yellow (BY) dissolved in dimethylformamide (DMF) may be coated on the substrate, and the photoalignment material layer may be patterned using polarization interference patterns generated by two orthogonal circularly polarized light beams (e.g., a left-handed circularly polarized beam and a right-handed circularly polarized beam) as described above with respect to FIG. 15B, or using direct laser writing techniques as described above with respect to FIG. 15E. In another example, a negative photoresist may be coated on the substrate and may then be patterned by nanoimprinting and UV curing as described above with respect to FIGS. 16A and 16B.

Operations at block 1730 may include coating one or more layers of liquid crystal materials on the alignment layer. The liquid crystal materials may include liquid crystal molecules mixed with photocurable monomers or polymers to form polymerizable liquid crystal reactive mesogens. In some examples, the liquid crystal materials may also include a photoinitiator, a chiral dopant, and/or a dichroic dye. The liquid crystal molecules in the liquid crystal materials coated on the alignment layer may align with patterns in the alignment layer. In some examples, the liquid crystal molecules may be twisted to form helical structures.

Operations at block 1740 may include curing the one or more layers of the liquid crystal materials, for example, using UV light, to form an array of polarization diffraction micro-lenses. The curing may polymerize photocurable monomers or cross-link polymers in the liquid crystal materials to form crosslinked polymers that may stabilize the liquid crystal molecules. In some examples, the one or more layers of the liquid crystal materials may be coated layer by layer on the alignment layer, until a desired thickness and/or twist angle (e.g., to achieve a half-wave retardation for high diffraction efficiency) is reached, and then the one or more layers of the liquid crystal materials may be cured using UV light. In some examples, a layer of a liquid crystal material may be coated and cured, and then another layer of the liquid crystal material may be coated and cured, until a desired thickness and/or twist angle is reached.

Optional operations at block 1750 may include bonding the array of polarization diffraction micro-lenses to the layer stack if the alignment layer is not formed on the layer stack. For example, the array of polarization diffraction micro-lenses may be bonded to the array of micro-LEDs or the array of color filters of the layer stack using an optically clear adhesive.

Optional operations at block 1760 may include attaching a cover glass to the bonded structure if the alignment layer is not formed on the cover glass. The cover glass may be attached to the bonded structures using an optically clear adhesive. Optional operations at block 1770 may include attaching a circular polarizer to the cover glass, for example, using an adhesive and/or a spacer. As described above, in some examples, the circular polarizer may include a linear polarizer and at least one quarter waveplate.

Embodiments disclosed herein may be used to implement components of an artificial reality system or may be implemented in conjunction with an artificial reality system. Artificial reality is a form of reality that has been adjusted in some manner before presentation to a user, which may include, for example, a virtual reality, an augmented reality, a mixed reality, a hybrid reality, or some combination and/or derivatives thereof. Artificial reality content may include completely generated content or generated content combined with captured (e.g., real-world) content. The artificial reality content may include video, audio, haptic feedback, or some combination thereof, and any of which may be presented in a single channel or in multiple channels (such as stereo video that produces a three-dimensional effect to the viewer). Additionally, in some embodiments, artificial reality may also be associated with applications, products, accessories, services, or some combination thereof, that are used to, for example, create content in an artificial reality and/or are otherwise used in (e.g., perform activities in) an artificial reality. The artificial reality system that provides the artificial reality content may be implemented on various platforms, including an HMD connected to a host computer system, a standalone HMD, a mobile device or computing system, or any other hardware platform capable of providing artificial reality content to one or more viewers.

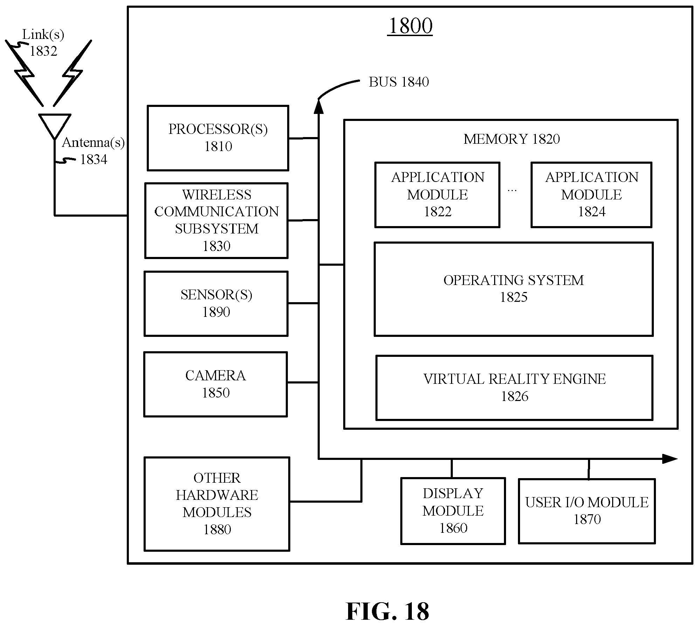

FIG. 18 is a simplified block diagram of an example of an electronic system 1800 of a near-eye display (e.g., HMD device) for implementing some of the examples disclosed herein. Electronic system 1800 may be used as the electronic system of an HMD device or other near-eye displays described above. In this example, electronic system 1800 may include one or more processor(s) 1810 and a memory 1820. Processor(s) 1810 may be configured to execute instructions for performing operations at a number of components, and can be, for example, a general-purpose processor or microprocessor suitable for implementation within a portable electronic device. Processor(s) 1810 may be communicatively coupled with a plurality of components within electronic system 1800. To realize this communicative coupling, processor(s) 1810 may communicate with the other illustrated components across a bus 1840. Bus 1840 may be any subsystem adapted to transfer data within electronic system 1800. Bus 1840 may include a plurality of computer buses and additional circuitry to transfer data.

Memory 1820 may be coupled to processor(s) 1810. In some examples, memory 1820 may offer both short-term and long-term storage and may be divided into several units. Memory 1820 may be volatile, such as static random access memory (SRAM) and/or dynamic random access memory (DRAM) and/or non-volatile, such as read-only memory (ROM), flash memory, and the like. Furthermore, memory 1820 may include removable storage devices, such as secure digital (SD) cards. Memory 1820 may provide storage of computer-readable instructions, data structures, program modules, and other data for electronic system 1800. In some examples, memory 1820 may be distributed into different hardware modules. A set of instructions and/or code might be stored on memory 1820. The instructions might take the form of executable code that may be executable by electronic system 1800, and/or might take the form of source and/or installable code, which, upon compilation and/or installation on electronic system 1800 (e.g., using any of a variety of generally available compilers, installation programs, compression/decompression utilities, etc.), may take the form of executable code.

In some examples, memory 1820 may store a plurality of application modules 1822 through 1824, which may include any number of applications. Examples of applications may include gaming applications, conferencing applications, video playback applications, or other suitable applications. The applications may include a depth sensing function or eye tracking function. Application modules 1822-1824 may include particular instructions to be executed by processor(s) 1810. In some examples, certain applications or parts of application modules 1822-1824 may be executable by other hardware modules 1880. In certain examples, memory 1820 may additionally include secure memory, which may include additional security controls to prevent copying or other unauthorized access to secure information.

In some examples, memory 1820 may include an operating system 1825 loaded therein. Operating system 1825 may be operable to initiate the execution of the instructions provided by application modules 1822-1824 and/or manage other hardware modules 1880 as well as interfaces with a wireless communication subsystem 1830 which may include one or more wireless transceivers. Operating system 1825 may be adapted to perform other operations across the components of electronic system 1800 including threading, resource management, data storage control and other similar functionality.

Wireless communication subsystem 1830 may include, for example, an infrared communication device, a wireless communication device and/or chipset (such as a Bluetooth® device, an IEEE 802.11 device, a Wi-Fi device, a WiMax device, cellular communication facilities, etc.), and/or similar communication interfaces. Electronic system 1800 may include one or more antennas 1834 for wireless communication as part of wireless communication subsystem 1830 or as a separate component coupled to any portion of the system. Depending on desired functionality, wireless communication subsystem 1830 may include separate transceivers to communicate with base transceiver stations and other wireless devices and access points, which may include communicating with different data networks and/or network types, such as wireless wide-area networks (WWANs), wireless local area networks (WLANs), or wireless personal area networks (WPANs). A WWAN may be, for example, a WiMax (IEEE 802.16) network. A WLAN may be, for example, an IEEE 802.11x network. A WPAN may be, for example, a Bluetooth network, an IEEE 802.15x, or some other types of network. The techniques described herein may also be used for any combination of WWAN, WLAN, and/or WPAN. Wireless communications subsystem 1830 may permit data to be exchanged with a network, other computer systems, and/or any other devices described herein. Wireless communication subsystem 1830 may include a means for transmitting or receiving data, such as identifiers of HMD devices, position data, a geographic map, a heat map, photos, or videos, using antenna(s) 1834 and wireless link(s) 1832. Wireless communication subsystem 1830, processor(s) 1810, and memory 1820 may together comprise at least a part of one or more of a means for performing some functions disclosed herein.

Examples of electronic system 1800 may also include one or more sensors 1890. Sensor(s) 1890 may include, for example, an image sensor, an accelerometer, a pressure sensor, a temperature sensor, a proximity sensor, a magnetometer, a gyroscope, an inertial sensor (e.g., a module that combines an accelerometer and a gyroscope), an ambient light sensor, or any other similar module operable to provide sensory output and/or receive sensory input, such as a depth sensor or a position sensor. For example, in some implementations, sensor(s) 1890 may include one or more inertial measurement units (IMUs) and/or one or more position sensors. An IMU may generate calibration data indicating an estimated position of the HMD device relative to an initial position of the HMD device, based on measurement signals received from one or more of the position sensors. A position sensor may generate one or more measurement signals in response to motion of the HMD device. Examples of the position sensors may include, but are not limited to, one or more accelerometers, one or more gyroscopes, one or more magnetometers, another suitable type of sensor that detects motion, a type of sensor used for error correction of the IMU, or any combination thereof. The position sensors may be located external to the IMU, internal to the IMU, or any combination thereof. At least some sensors may use a structured light pattern for sensing.

Electronic system 1800 may include a display module 1860. Display module 1860 may be a near-eye display, and may graphically present information, such as images, videos, and various instructions, from electronic system 1800 to a user. Such information may be derived from one or more application modules 1822-1824, virtual reality engine 1826, one or more other hardware modules 1880, a combination thereof, or any other suitable means for resolving graphical content for the user (e.g., by operating system 1825). Display module 1860 may use LCD technology, LED technology (including, for example, OLED, ILED, µ-LED, AMOLED, TOLED, etc.), light emitting polymer display (LPD) technology, or some other display technology.

Electronic system 1800 may include a user input/output module 1870. User input/output module 1870 may allow a user to send action requests to electronic system 1800. An action request may be a request to perform a particular action. For example, an action request may be to start or end an application or to perform a particular action within the application. User input/output module 1870 may include one or more input devices. Example input devices may include a touchscreen, a touch pad, microphone(s), button(s), dial(s), switch(es), a keyboard, a mouse, a game controller, or any other suitable device for receiving action requests and communicating the received action requests to electronic system 1800. In some examples, user input/output module 1870 may provide haptic feedback to the user in accordance with instructions received from electronic system 1800. For example, the haptic feedback may be provided when an

24

action request is received or has been performed.

Electronic system 1800 may include a camera 1850 that may be used to take photos or videos of a user, for example, for tracking the user's eye position. Camera 1850 may also be used to take photos or videos of the environment, for example, for VR, AR, or MR applications. Camera 1850 may include, for example, a complementary metal-oxide-semiconductor (CMOS) image sensor with a few millions or tens of millions of pixels. In some implementations, camera 1850 may include two or more cameras that may be used to capture 3-D images.

In some examples, electronic system 1800 may include a plurality of other hardware modules 1880. Each of other hardware modules 1880 may be a physical module within electronic system 1800. While each of other hardware modules 1880 may be permanently configured as a structure, some of other hardware modules 1880 may be temporarily configured to perform specific functions or temporarily activated. Examples of other hardware modules 1880 may include, for example, an audio output and/or input module (*e.g.*, a microphone or speaker), a near field communication (NFC) module, a rechargeable battery, a battery management system, a wired/wireless battery charging system, etc. In some examples, one or more functions of other hardware modules 1880 may be implemented in software.

In some examples, memory 1820 of electronic system 1800 may also store a virtual reality engine 1826. Virtual reality engine 1826 may execute applications within electronic system 1800 and receive position information, acceleration information, velocity information, predicted future positions, or any combination thereof of the HMD device from the various sensors. In some examples, the information received by virtual reality engine 1826 may be used for producing a signal (*e.g.*, display instructions) to display module 1860. For example, if the received information indicates that the user has looked to the left, virtual reality engine 1826 may generate content for the HMD device that mirrors the user's movement in a virtual environment. Additionally, virtual reality engine 1826 may perform an action within an application in response to an action request received from user input/output module 1870 and provide feedback to the user. The provided feedback may be visual, audible, or haptic feedback. In some implementations, processor(s) 1810 may include one or more graphic processing units GPUs that may execute virtual reality engine 1826.

In various implementations, the above-described hardware and modules may be implemented on a single device or on multiple devices that can communicate with one another using wired or wireless connections. For example, in some implementations, some components or modules, such as GPUs, virtual reality engine 1826, and applications (*e.g.*, tracking application), may be implemented on a console separate from the head-mounted display device. In some implementations, one console may be connected to or support more than one HMD.

In alternative configurations, different and/or additional components may be included in electronic system 1800. Similarly, functionality of one or more of the components can be distributed among the components in a manner different from the manner described above. For example, electronic system 1800 may be modified to include other system environments, such as an AR system environment and/or an MR environment.

The methods, systems, and devices discussed above are examples. Various embodiments may omit, substitute, or add various procedures or components as appropriate. For instance, in alternative configurations, the methods described may be performed in an order different from that described, and/or various stages may be added, omitted, and/or combined. Also, features described with respect to certain embodiments may be combined in various other embodiments. Different aspects and elements of the embodiments may be combined in a similar manner. Also, technology evolves and, thus, many of the elements are examples that do not limit the scope of the disclosure to those specific examples.

Specific details are given in the description to provide a thorough understanding of the embodiments. However, embodiments may be practiced without these specific details. For example, well-known circuits, processes, systems, structures, and techniques have been shown without unnecessary detail in order to avoid obscuring the embodiments. This description provides example embodiments only, and is not intended to limit the scope, applicability, or configuration of the invention. Rather, the preceding description of the embodiments will provide those skilled in the art with an enabling description for implementing various embodiments. Various changes may be made in the function and arrangement of elements without departing from the scope of the present disclosure.

Also, some embodiments were described as processes depicted as flow diagrams or block diagrams. Although each may describe the operations as a sequential process, many of the operations may be performed in parallel or concurrently. In addition, the order of the operations may be rearranged. A process may have additional steps not included in the figure. Furthermore, embodiments of the methods may be implemented by hardware, software, firmware, middleware, microcode, hardware description languages, or any combination thereof. When implemented in software, firmware, middleware, or microcode, the program code or code segments to perform the associated tasks may be stored in a computer-readable medium such as a storage medium. Processors may perform the associated tasks.

It will be apparent to those skilled in the art that substantial variations may be made in accordance with specific requirements. For example, customized or special-purpose hardware might also be used, and/or particular elements might be implemented in hardware, software (including portable software, such as applets, etc.), or both. Further, connection to other computing devices such as network input/output devices may be employed.

With reference to the appended figures, components that can include memory can include non-transitory machine-readable media. The term "machine-readable medium" and "computer-readable medium" may refer to any storage medium that participates in providing data that causes a machine to operate in a specific fashion. In embodiments provided hereinabove, various machine-readable media might be involved in providing instructions/code to processing units and/or other device(s) for execution. Additionally or alternatively, the machine-readable media might be used to store and/or carry such instructions/code. In many implementations, a computer-readable medium is a physical and/or tangible storage medium. Such a medium may take many forms, including, but not limited to, non-volatile media, volatile media, and transmission media. Common forms of computer-readable media include, for example, magnetic and/or optical media such as compact disk (CD) or digital versatile disk (DVD), punch cards, paper tape, any other physical medium with patterns of holes, a RAM, a programmable read-only memory (PROM), an erasable programmable read-only memory (EPROM), a FLASH-EPROM, any other memory chip or cartridge, a carrier wave as described hereinafter, or any other medium from which a computer can read instructions and/or code. A computer program product may include code and/or machine-executable instructions that may represent a procedure, a function, a subprogram, a program, a routine, an application (App), a subroutine, a module, a software package, a class, or any combination of instructions, data structures, or program statements.

Those of skill in the art will appreciate that information and signals used to communicate the messages described herein may be represented using any of a variety of different technologies and techniques. For example, data, instructions, commands, information, signals, bits, symbols, and chips that may be referenced throughout the above description may be represented by voltages, currents, electromagnetic waves, magnetic fields or particles, optical fields or particles, or any combination thereof.

Terms "and" and "or," as used herein, may include a variety of meanings that are also expected to depend at least in part upon the context in which such terms are used. Typically, "or" if used to associate a list, such as A, B, or C, is intended to mean A, B, and C, here used in the inclusive sense, as well as A, B, or C, here used in the exclusive sense. In addition, the term "one or more" as used herein may be used to describe any feature, structure, or characteristic in the singular or may be used to describe some combination of features, structures, or characteristics. However, it should be noted that this is merely an illustrative example and claimed subject matter is not limited to this example. Furthermore, the term "at least one of" if used to associate a list, such as A, B, or C, can be interpreted to mean A, B, C, or any combination of A, B, and/or C, such as AB, AC, BC, AA, ABC, AAB, AABBCCC, or the like.

Further, while certain embodiments have been described using a particular combination of hardware and software, it should be recognized that other combinations of hardware and software are also possible. Certain embodiments may be implemented only in hardware, or only in software, or using combinations thereof. In one example, software may be implemented with a computer program product containing computer program code or instructions executable by one or more processors for performing any or all of the steps, operations, or processes described in this disclosure, where the computer program may be stored on a non-transitory computer readable medium. The various processes described herein can be implemented on the same processor or different processors in any combination.

Where devices, systems, components or modules are described as being configured to perform certain operations or functions, such configuration can be accomplished, for example, by designing electronic circuits to perform the operation, by programming programmable electronic circuits (such as microprocessors) to perform the operation such as by executing computer instructions or code, or processors or cores programmed to execute code or instructions stored on a non-transitory memory medium, or any combination thereof. Processes can communicate using a variety of techniques, including, but not limited to, conventional techniques for inter-process communications, and different pairs of processes may use different techniques, or the same pair of processes may use different techniques at different times.

The specification and drawings are, accordingly, to be regarded in an illustrative rather than a restrictive sense. It will, however, be evident that additions, subtractions, deletions, and other modifications and changes may be made thereunto without departing from the broader spirit and scope as set forth in the claims. Thus, although specific embodiments have been described, these are not intended to be limiting. Various modifications and equivalents are within the scope of the following claims.

## Claims

1.  A micro-light emitting diode (micro-LED) device comprising:

    a backplane including drive circuits formed thereon;
    an array of micro-LEDs bonded to the backplane and electrically coupled to the drive circuits;
    an array of polarization diffraction micro-lenses bonded to the array of micro-LEDs and including a planar surface, wherein a center of each polarization diffraction micro-lens of the array of polarization diffraction micro-lenses aligns with a center of a respective micro-LED of the array of micro-LEDs; and
    a cover glass bonded to the planar surface of the array of polarization diffraction micro-lenses.

**2.** The micro-LED device of claim 1, wherein the array of polarization diffraction micro-lenses is configured to collimate light beams emitted by the array of micro-LEDs;
preferably wherein the array of polarization diffraction micro-lenses is configured to deflect chief rays of light beams emitted by the array of micro-LEDs by different deflection angles that gradually increase from a center of the micro-LED device to an edge of the micro-LED device.

**3.** The micro-LED device of claim 1 or 2, wherein an optical axis of a polarization diffraction micro-lens of the array of polarization diffraction micro-lenses is offset from the center of the polarization diffraction micro-lens.

**4.** The micro-LED device of any preceding claim, wherein:

a first polarization diffraction micro-lens of the array of polarization diffraction micro-lenses is **characterized by** a first offset between an optical axis of the first polarization diffraction micro-lens and the center of the first polarization diffraction micro-lens; and
a second polarization diffraction micro-lens of the array of polarization diffraction micro-lenses is **characterized by** a second offset between an optical axis of the second polarization diffraction micro-lens and the center of the second polarization diffraction micro-lens, wherein the second offset is different from the first offset.

**5.** The micro-LED device of any preceding claim, wherein each polarization diffraction micro-lens of the array of polarization diffraction micro-lenses is **characterized by** a positive optical power for light of a first circular polarization state and a negative optical power for light of a second circular polarization state.

**6.** The micro-LED device of any preceding claim, wherein the array of polarization diffraction micro-lenses includes Pancharatnam-Berry Phase (PBP) micro-lenses;
preferably wherein the micro-LED device further comprises a circular polarizer.

**7.** The micro-LED device of any preceding claim, wherein each polarization diffraction micro-lens of the array of polarization diffraction micro-lenses includes:

an alignment layer including an alignment pattern formed thereon; and
liquid crystal molecules arranged according to the alignment pattern;
preferably wherein a pitch of the array of micro-LEDs is equal to a pitch of the array of polarization diffraction micro-lenses.

**8.** The micro-LED device of any preceding claim, wherein the array of micro-LEDs includes:

an array of micro-organic light emitting diodes (micro-OLEDs) configured to emit red, green, and blue light;
an array of III-V semiconductor micro-LEDs configured to emit red, green, and blue light; or
an array of color filters and an array of micro-OLEDs configured to emit white light.

**9.** The micro-LED device of any preceding claim, wherein the array of micro-LEDs includes an array of pixels, each pixel of the array of pixels including:

a first micro-LED configured to emit light in a first wavelength range;
a second micro-LED configured to emit light in a second wavelength range; and
a third micro-LED configured to emit light in a third wavelength range,
wherein three polarization diffraction micro-lenses of the array of polarization diffraction micro-lenses are configured to deflect chief rays of light beams emitted by the first micro-LED, the second micro-LED, and the third micro-LED by a same deflection angle.

**10.** A near-eye display system comprising:

an image source configured to generate display light, the image source comprising:

a backplane including drive circuits formed thereon;
an array of micro-LEDs bonded to the backplane and electrically coupled to the drive circuits;
an array of polarization diffraction micro-lenses aligned with the array of micro-LEDs and including a planar surface, wherein a pitch of the array of polarization diffraction micro-lenses is equal to a pitch of the array of micro-LEDs; and
a cover glass bonded to the planar surface of the array of polarization diffraction micro-lenses; and

display optics configured to project the display light emitted by the image source to an eye box of the near-eye display system.

11. The near-eye display system of claim 10, wherein the array of polarization diffraction micro-lenses is configured to direct chief rays of light beams emitted by the array of micro-LEDs onto the display optics at different incident angles; preferably wherein the array of polarization diffraction micro-lenses is configured to deflect chief rays of light beams emitted by the array of micro-LEDs by different deflection angles that gradually increase from a center of the image source to an edge of the image source.

12. The near-eye display system of claim 10 or 11, wherein an optical axis of a polarization diffraction micro-lens of the array of polarization diffraction micro-lenses is offset from a center of the polarization diffraction micro-lens.

13. The near-eye display system of any of claims 10 to 12, wherein the array of polarization diffraction micro-lenses includes Pancharatnam-Berry Phase (PBP) micro-lenses, each PBP micro-lens of the PBP micro-lenses **characterized by** a positive optical power for light of a first circular polarization state and a negative optical power for light of a second circular polarization state;
preferably wherein the near-eye display system further comprises a circular polarizer between the image source and the display optics

14. The near-eye display system of any of claims 10 to 13, wherein each polarization diffraction micro-lens of the array of polarization diffraction micro-lenses includes:

an alignment layer including an alignment pattern formed thereon; and
liquid crystal molecules arranged according to the alignment pattern.

15. The near-eye display system of any of claims 10 to 14, wherein the array of micro-LEDs includes:

an array of micro-organic light emitting diodes (micro-OLEDs) configured to emit red, green, and blue light;
an array of III-V semiconductor micro-LEDs configured to emit red, green, and blue light; or
an array of color filters and an array of micro-OLEDs configured to emit white light.

**FIG. 1**

EP 4 261 574 A1

**FIG. 2**

**FIG. 3**

**FIG. 4**

EP 4 261 574 A1

FIG. 5

**FIG. 6**

EP 4 261 574 A1

700

790

780

770

740    760    750

720    730

710

z
y    x

**FIG. 7A**

702

762

745

722    732

712

**FIG. 7B**

800

810

820

830

820

810

d

z

x

y

**FIG. 8A**

800

830

y

x

0

Λ

2Λ

**FIG. 8B**

FIG. 9A

FIG. 9B

**FIG. 10A**                                         **FIG. 10B**

EP 4 261 574 A1

**FIG. 11A**

**FIG. 11B**

**FIG. 11C**

**FIG. 12A**

**FIG. 12B**

EP 4 261 574 A1

1300

1370

1340    1360    1342    1350

R    G    B    R    G    B

1320    1330    1322    1310

**FIG. 13A**

1305

1375

1365

1345-b    1345-a    1345    1345-c

z

1325    1335

x

y    1315

**FIG. 13B**

1345-b    1345-a    1345-c

y    . . .    . . .

x

**FIG. 13C**

FIG. 14

**FIG. 15A**

**FIG. 15B**

**FIG. 15C**

**FIG. 15D**

**FIG. 15E**

EP 4 261 574 A1

FIG. 16D

FIG. 16C

FIG. 16B

FIG. 16A

1660

1650

1622

1610

1642

1610

1630

1620

1610

1622

1600

1620

1610

1700

1710
Obtain a layer stack including drive circuits, an array of micro-LEDs, and, optionally, an array of color filters

1720
Form an alignment layer on a substrate (e.g., a glass substrate) or on the layer stack

1730
Coat one or more layers of liquid crystal materials on the alignment layer

1740
Cure the one or more layers of the liquid crystal materials to form an array of polarization diffraction micro-lenses

1750
Bond the array of polarization diffraction micro-lenses to the layer stack

1760
Attach a cover glass to the bonded structure

1770
Attach a circular polarizer to the cover glass

**FIG. 17**

**FIG. 18**

Europäisches
Patentamt

European
Patent Office

Office européen
des brevets

# EUROPEAN SEARCH REPORT

Application Number

EP 23 16 3858

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2021/405255 A1 (KRESS GREGORY [US] ET AL) 30 December 2021 (2021-12-30) | 1-4, 8-11,15 | INV. G02B3/00 |
| Y | * paragraph [0046] - paragraph [0167] * <br> * figures 7, 9 * | 5-7,13, 14 | G02B3/14 G02B5/30 G02B26/06 |
| | ----- | | G02B27/00 |
| Y | US 2021/231952 A1 (JAMALI AFSOON [US] ET AL) 29 July 2021 (2021-07-29) | 5-7,13, 14 | G02B27/01 G02F1/01 |
| A | * paragraph [0069] - paragraph [0148] * <br> * figure 5 * | 1-4, 8-12,15 | |
| | ----- | | |
| A | ENGELBERG JACOB ET AL: "The advantages of metalenses over diffractive lenses", NATURE COMMUNICATIONS, vol. 11, no. 1, 24 April 2020 (2020-04-24) , XP093079133, DOI: 10.1038/s41467-020-15972-9 Retrieved from the Internet: URL:https://www.nature.com/articles/s41467 -020-15972-9.pdf> * the whole document * | 1-15 | |
| | ----- | | |

TECHNICAL FIELDS SEARCHED (IPC)

G02B
G02F

The present search report has been drawn up for all claims

| Place of search | Date of completion of the search | Examiner |
|---|---|---|
| The Hague | 6 September 2023 | Szachowicz, Marta |

EPO FORM 1503 03.82 (P04C01)

## ANNEX TO THE EUROPEAN SEARCH REPORT
## ON EUROPEAN PATENT APPLICATION NO.

EP 23 16 3858

This annex lists the patent family members relating to the patent documents cited in the above-mentioned European search report.
The members are as contained in the European Patent Office EDP file on
The European Patent Office is in no way liable for these particulars which are merely given for the purpose of information.

06-09-2023

| Patent document cited in search report | | Publication date | Patent family member(s) | | Publication date |
|---|---|---|---|---|---|
| US 2021405255 | A1 | 30-12-2021 | EP | 4172666 A1 | 03-05-2023 |
| | | | JP | 2023534405 A | 09-08-2023 |
| | | | KR | 20230034335 A | 09-03-2023 |
| | | | US | 2021405255 A1 | 30-12-2021 |
| | | | WO | 2022005847 A1 | 06-01-2022 |
| US 2021231952 | A1 | 29-07-2021 | CN | 115039010 A | 09-09-2022 |
| | | | EP | 4094111 A1 | 30-11-2022 |
| | | | JP | 2023510479 A | 14-03-2023 |
| | | | KR | 20220126774 A | 16-09-2022 |
| | | | US | 2021231952 A1 | 29-07-2021 |
| | | | US | 2023204964 A1 | 29-06-2023 |
| | | | WO | 2021150308 A1 | 29-07-2021 |

EPO FORM P0459